(19) Europäisches Patentamt

European Patent Office

Office européen des brevets

(11) Veröffentlichungsnummer : **0 349 743 B1**

(12) **EUROPÄISCHE PATENTSCHRIFT**

(45) Veröffentlichungstag der Patentschrift :
**30.11.94 Patentblatt 94/48**

(51) Int. Cl.⁵ : **H03F 3/217**

(21) Anmeldenummer : **89109011.0**

(22) Anmeldetag : **19.05.89**

(54) **Leistungsverstärker.**

(30) Priorität : **07.07.88 DE 3822957**
**11.03.89 DE 3907919**

(43) Veröffentlichungstag der Anmeldung :
**10.01.90 Patentblatt 90/02**

(45) Bekanntmachung des Hinweises auf die
Patenterteilung :
**30.11.94 Patentblatt 94/48**

(84) Benannte Vertragsstaaten :
**CH DE FR GB LI**

(56) Entgegenhaltungen :
**EP-A- 0 066 904**
**EP-A- 0 267 391**
**DE-A- 3 502 135**

(73) Patentinhaber : **TELEFUNKEN Sendertechnik**
**GmbH**
**Sickingenstrasse 20-28**
**D-10553 Berlin (DE)**

(72) Erfinder : **Beeken, Horst, Dipl.-Ing.**
**Teltower Strasse 20**
**D-1000 Berlin 20 (DE)**

(74) Vertreter : **Schulze, Harald Rudolf, Dipl.-Ing.**
**Deutsche Aerospace AG,**
**Patentabteilung,**
**Sedanstrasse 10**
**D-89077 Ulm (DE)**

EP 0 349 743 B1

## Beschreibung

Die Erfindung betrifft einen Leistungsverstärker gemäß Oberbegriff des Patentanspruchs 1. Ein solcher Leistungsverstärker ist beispielsweise aus der DE-A1-35 02 135 bekannt.

Der dort beschriebene bekannte Leistungsverstärker besteht aus mehreren gleichartigen Einzelverstärkern, die ausgangsseitig in Reihe geschaltet sind und die jeweils aus einem sekundärseitig geschalteten Schaltverstärker und einem nachgeschalteten Tiefpaßfilter bestehen.

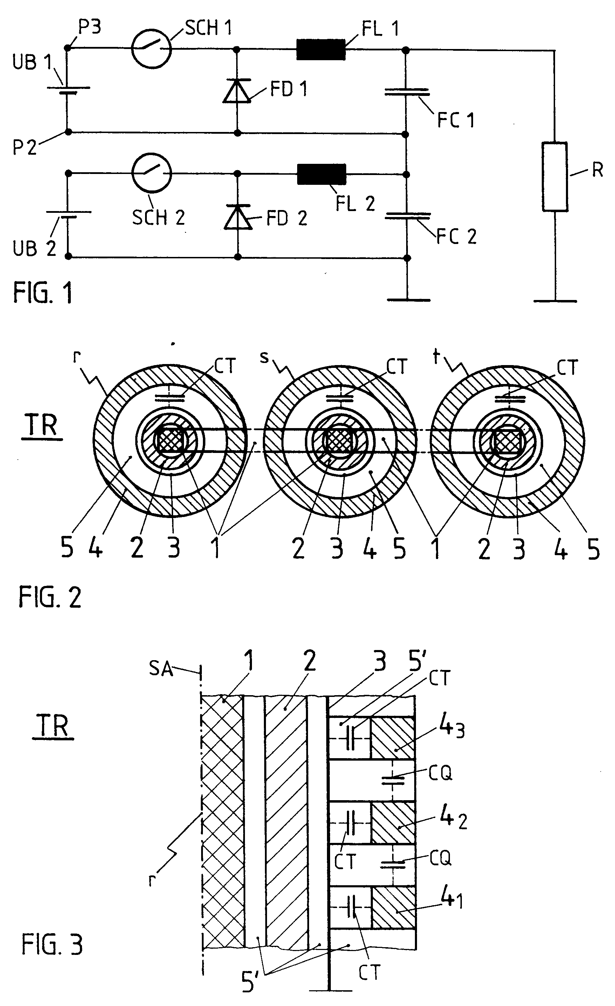

Die sekundärseitig geschalteten Schaltverstärker bestehen gemäß FIG. 1 jeweils aus einem Gleichspannungsnetzgerät UB1 bzw. UB2 sowie aus einem nachgeschalteten Schalter SCH1 bzw. SCH2 der durch eine aus dem zu verstärkenden analogen Eingangssignal abgeleitete Impulsfolge angesteuert wird. Zur Überbrückung des jeweiligen Gleichspannungsnetzgeräts UB1 bzw. UB2 bei geöffnetem Schalter SCH1 bzw. SCH2 ist ferner ausgangsseitig jeweils eine Freilaufdiode FD1 bzw. FD2 angeordnet.

Ein solches Gleichspannungsgerät (z.B. UB1 in Fig. 1) besteht üblicherweise aus einem Netztransformator, der beispielsweise als Drehstromtransformator ausgeführt sein kann mit drei im Dreieck geschalteten Primärwicklungen und drei im Stern geschalteten Sekundärwicklungen. An die Sekundärwicklungen ist üblicherweise ein Drehstrom-Brückengleichrichter angeschlossen, dem zur Glättung der erzeugten Roh-Gleichspannung ein Siebglied mit Siebdrossel und Siebkondensator nachgeschaltet ist, wobei die Siebdrossel zwischen dem positiven Pol der Gleichrichterschaltung und der potentialmäßig hochliegenden Ausgangsklemme angeschlossen ist und der Siebkondensator parallel zu den beiden Ausgangsklemmen geschaltet ist.

Nach derzeitigem Stand der Technik ist für ein Gleichspannungsnetzgerät bis zu einer Leistung von ungefähr 200 kW bei einer Gleichspannung von ungefähr 30 kV eine an der Primärseite des Netztransformators anliegende Netzspannung von 380V bei einer Frequenz von 50 Hz oder 60 Hz verwendbar. Für Leistungen über 250 kW werden bei einer 380 V-Netzspannung die auftretenden Primärströme sehr groß und daher technisch schwer beherrschbar. In diesem Fall werden daher Spannungen zwischen 4 $kV_{eff}$ und 30 $kV_{eff}$ auf der Primärseite des Netztransformators verwendet.

Ein sehr kostengünstig herstellbarer Netztransformator ist als sogenannter Gießharztransformator ausgebildet, der es ermöglicht, die vielen Anschlüsse der Sekundärwicklungen in kostengünstiger Weise herauszuführen. Ein solcher Gießharztransformator ist jedoch nur für eine Primärspannung von 380V wirtschaftlich anwendbar.

FIG. 2 zeigt einen Querschnitt durch einen solchen Gießharztransformator TR, der als 3-Phasen-Drehstromtransformator ausgebildet ist. Um einen Eisenkern 1, der z.B. als sogenannter EI-Schnitt ausgebildet ist, sind drei Spuleneinheiten r, s, t gewickelt, entsprechend den drei Phasen des Drehstromes. Jede Spuleneinheit besteht aus einer unmittelbar um den Eisenkern 1 gewickelten Primärspule 2, einem diese umgebenden und an Masse angeschlossenen Schirmung 3 und einer diesen umgebenden Sekundärwicklung 4, deren Windungen mit Gießharz vergossen sind. Zur elektrischen Isolierung ist zwischen Schirmung 3 und Sekundärwicklung 4 ein Luftkanal 5 vorhanden, der z.B. eine Durchschlagfestigkeit von 50kV besitzt. Zwischen Eisenkern 1 und Primärwicklung 2, Primärwicklung 2 und Schirmung 3, Schirmung 3 und Sekundärwicklung 4 ist jeweils eine Durchschlagfestigkeit von mindestens 2,5 kV vorhanden. Aus FIG. 2 ist ersichtlich, daß der in nachteiliger Weise viel Raum beanspruchende Luftkanal 5 lediglich einmal vorhanden ist. Elektrische Isolierungen für Isolierspannungen von 2,5kV sind dagegen wesentlich raumsparender ausführbar, z.B. mit Hilfe von Kunststoffolien. Die Anschlüsse sind aus dem Gießharz leicht auf der Außenseite der Gießharzspule herauszuführen.

Würde nun in gleicher Technologie ein Netztransformator für Leistungen größer 250 kW aufgebaut, also für eine Netzeingangsspannung von z.B. 20 kV, so müßte der isolierende Luftkanal 5 für 50 kV dreimal vorhanden sein, nämlich zwischen Eisenkern 1 und Primärwicklung 2, zwischen Primärwicklung 2 und Schirmung 3 und zwischen Schirmung 3 und Sekundärwicklung 4. Ein solcher Netztransformator würde sehr große Ausmaße besitzen und ist daher wirtschaftlich nicht verwendbar.

Für derartig große Leistungen (größer 250 kW) ist daher lediglich ein Netztransformator verwendbar, in dem ein flüssiges Isoliermaterial, z.B. sogenanntes Transformatorenöl, mit einer möglichst hohen elektrischen Durchschlagfestigkeit verwendet wird. Damit ist zwar ein relativ räumlich kleiner Netztransformator herstellbar, da die elektrisch isolierenden Abstände entsprechend der minimalen Durchschlagfestigkeit des flüssigen Isoliermaterials zu wählen sind. Diese ist jedoch gegenüber Luft wesentlich größer und beträgt z.B. mindestens 30 kV/2,5mm.

Ein Ausführungsbeispiele eines solchen Netztransformators ist im Ausschnitt in FIG. 3 gezeigt. Der Ausschnitt zeigt einen Schenkel r eines mit flüssigem Isoliermaterial 5' (z.B. Transformatorenöl) gefüllten Drehstromtransformators TR mit einem Eisenkern 1, einer Primärwicklung 2, einer an Masse liegenden Schirmung 3 sowie mehreren in Kammerwicklungstechnik ausgeführten Sekundärwicklung $4_1$ bis $4_3$ im Längsschnitt. Wegen der Rotationssymmetrie im Aufbau des Schenkels r ist nur eine Hälfte des Schenkels r gezeigt. Die Symmetrieachse SA verläuft dabei durch den Eisenkern 1.

EP 0 349 743 B1

Die Tiefpaßfilter bei dem bekannten Leistungsverstärker bestehen jeweils aus einem LC-Halbglied mit Filterspule FL 1 bzw. FL2 und Filterkondensator FC1 bzw. FC2 und sind in ihrer oberen Grenzfrequenz so dimensioniert, daß am Verstärkerausgang das analoge Eingangssignal verstärkt und im wesentlichen unverzerrt an die Last R abgegeben wird.

Die Reihenschaltung der Einzelverstärker wird bei dem bekannten Leistungsverstärker dadurch realisiert, daß die Filterkondensatoren FC1 bzw. FC2 der einzelnen LC-Halbglieder in Reihe geschaltet sind.

Ähnliche Leistungsverstärker, jedoch mit primärseitig geschalteten Schaltverstärkern bzw. mit parallel geschalteten Einzelverstärkern, sind aus der EP-A1-0 025 234 bzw. der DE-A1-2 841 833 bekannt.

Zur Ansteuerung der Schaltelemente in den einzelnen Schaltverstärkern dienen bei den bekannten Leistungsverstärkern pulsdauermodulierte ("PDM") Impulsfolgen, die in an sich bekannten Schaltungen durch hochfrequente Abtastung aus dem analogen Eingangssignal abgeleitet werden und bei denen die Breite bzw. die Dauer der einzelnen Impulse direkt proportional zum abgetasteten Momentanwert der Amplitude des analogen Eingangssignals ist. Sofern die (bei PDM konstante) Abtast- oder Schaltfrequenz mindestens doppelt so hoch ist wie die maximal zulässige Frequenz des Eingangssignals, enthält jede einzelne dieser Impulsfolgen dabei die vollständige Information über das zu verstärkende analoge Eingangssignal, wobei in besonderen Ausführungsformen solcher Leistungsverstärker die Impulsfolgen gegeneinander phasenverschoben das analoge Eingangssignal abtasten. Die Grenzfrequenz der einzelnen Tiefpaßfilter ist daher so gewählt, daß aus den pulsdauermodulierten Leistungsimpulsen am Ausgang des entsprechenden Schaltverstärkers in dem nachgeschalteten Filter die Abtastfrequenz einschließlich ihrer Oberschwingungen herausgefiltert wird und auf diese Art und Weise das analoge Eingangssignal verstärkt und im wesentlichen unverzerrt am Ausgang des Tiefpaßfilters abgegeben wird.

Grundlagen der Dimensionierung der einzelnen Tiefpaßfilter sind bei den bekannten Leistungsverstärkern einzig und allein die Kapazitäten und Induktivitäten der in den Tiefpaßfiltern verwendeten Filterkondensatoren (FC1 und FC2 in FIG. 1) und Filterspulen(FL1 und FL2 in FIG. 1).

Während mit den bekannten Leistungsverstärkern mit entsprechend dimensioniert Tiefpaßfiltern eine nahezu verzerrungsfreie Verstärkung des analogen Eingangssignals durchaus realisierbar ist, wird der wegen des Einsatzes von Schaltverstärkern anstelle von Linearverstärkern theoretisch zu erwartende hohe Wirkungsgrad mit den bekannten Verstärkern in der Praxis keineswegs erreicht.

Die Aufgabe der Erfindung besteht daher darin, einen Leistungsverstärker der eingangs genannten Art zu schaffen, der einen möglichst hohen Wirkungsgrad bei gleichzeitig möglichst geringer Verzerrung des Verstärkerausgangssignals aufweist.

Die erfindungsgemäße Lösung dieser Aufgabe ist in den Merkmalen des Patentanspruches 1 beschrieben. Die weiteren Ansprüche enthalten vorteilhafte Aus- und Weiterbildungen der Erfindung sowie bevorzugte Anwendungen der Erfindungen.

Eine wesentliche Ursache des in der Praxis überraschend geringen Wirkungsgrades der bekannten Leistungsverstärker ist die durch die hohe Abtast- bzw. Schaltfrequenz bedingte Verlustleistung in den Aufbaukapazitäten der in den Schaltverstärkern verwendeten Netztransformatoren. Bei Transformatoren TR mit an Masse angeschlossener Schirmung 3 wie z.B. bei den in FIG. 2 und 3 gezeigten Transformatoren sind es insbesondere die Schirmkapazitäten CT zwischen Schirmung 3 und Sekundärwicklungen 4 des Netztransformators (bei Netztransformatoren ohne Schirmung entsprechend die Wicklungskapazitäten zwischen Primär- und Sekundärwicklungen des Transformators), die für die hohe Verlustleistung in den Transformatoren verantwortlich sind. Aber auch die Querkapazitäten CQ zwischen räumlich benachbarten Sekundärwicklungen ($4_1$, $4_2$ und $4_3$ in FIG. 3) können erheblich zu diesen Verlusten beitragen.

Die Erfindung besteht nun darin, jeweils zwei direkt hintereinander in Reihe geschaltete Einzelverstärker so zu einem Verstärkermodul zusammenzufassen, daß diese an sich schädlichen Aufbaukapazitäten der Transformatoren, insbesondere die o.a. Schirmkapazitäten CT und/oder Querkapazitäten CQ Teile der einzelnen Tiefpaßfilter werden, so daß an den Transformatoren nicht mehr, wie bei den bekannten Leistungsverstärkern, die hohen Abtast, bzw. Schaltfrequenzen anliegen, sondern nur noch das abzutastende, niederfrequentere analoge Eingangssignal, was eine entsprechende Reduzierung der Verlustleistung in den Aufbaukapazitäten der Netztransformatoren zur Folge hat. Damit verbunden ist eine entsprechende Erhöhung des Wirkungsgrades des Leistungsverstärkers.

Zweckmäßigerweise wird bei der Dimensionierung der einzelnen Tiefpaßfilter bezüglich ihrer oberen Grenzfrequenz die als Tiefpaßfilter-Teile "integrierten" Transformatorkapazitäten (beispielsweise die o.a. Schirm- und/oder Querkapazitäten) mit einbezogen, sodaß dadurch der tatsächliche Filteraufwand reduziert werden kann.

Es versteht sich, daß neben den hier und im folgenden beispielhaft angeführten Schirm- bzw. Querkapazitäten CT bzw. CQ auch weitere "integrierbare" Transformatorkapazitäten bei der Dimensionierung der einzelnen Tiefpaßfilter berücksichtigt werden können.

Welche der "integrierbaren" Transformatorkapazitäten dabei wesentlich sind, hängt in entscheidendem Maße vom gewählten Aufbau des Netztransformators ab.

Im folgenden wird der erfindungsgemäße Leistungsverstärker anhand der Figuren insbesondere im Zusammenhang mit einem Modulationsverstärker für einen amplitudenmodulierten Hochleistungssender näher beschrieben, jedoch ist die Erfindung nicht auf diesen Anwendungsfall beschränkt. Vielmehr kann die Erfindung ganz allgemein zur verzerrungsarmen Verstärkung von analogen Signalen mit hohem Wirkungsgrad verwendet werden und eignet sich insbesondere für Hochleistungsanwendungen im Nieder- und Hochfrequenzbereich. Ein weiteres vorteilhaftes Anwendungsgebiet ist das Gebiet der Hochspannungs-Gleichstromversorgungen, beispielsweise für Magnetstromversorgungen in Teilchenbeschleunigeranlagen.

Die Figuren zeigen im einzelnen:

| | |
|---|---|
| FIG. 1 | den bereits diskutierten und an sich bekannten Leistungsverstärker mit mehreren ausgangsseitig in Reihe geschalteten Einzelverstärkern |
| FIG. 2 | den bereits diskutierten und an sich bekannten prinzipiellen Aufbau eines Gießharz-Drehstromtransformators im Querschnitt |
| FIG. 3 | den bereits diskutierten prinzipiellen Aufbau eines sekundärseitig in Kammerwicklungstechnik ausgeführten Schenkels eines mit flüssigen Isoliermaterial gefüllten Drehstromtransformators mit einer Primärwicklung und mehreren Sekundärwicklungen im Längsschnitt. |
| FIG. 4 | eine einphasig ausgebildete vorteilhafte Ausführungsform des erfindungsgemäßen Leistungsverstärkers mit einstufigen Tiefpaßfiltern |
| FIG. 5 | eine weitere, dreiphasig ausgebildete vorteilhafte Ausführungsform des erfindungsgemäßen Leistungsverstärkers mit zweistufigen Tiefpaßfiltern |
| FIG. 6-7 | Ersatzschaltbilder eines bekannten Leistungsverstärkers ohne "Integration" der Transformator-Schirmkapazität |
| FIG. 8-9 | Ersatzschaltbilder des erfindungsgemäßen Leistungsverstärkers gemäß FIG. 4 mit "integrierter" Schirmkapazität des Transformators |
| FIG. 10 und FIG. 11 | Ersatzschaltbilder eines Ausschnittes des erfindungsgemäßen Leistungsverstärkers gemäß FIG. 4 oder 5 mit den Schaltern und den Schalter-Ausgangskapazitäten |
| FIG. 12 | ein Blockschaltbild einer vorteilhaften Ausführungsform des erfindungsgemäßen Leistungsverstärkers für hohe Spannungen |
| FIG. 13 | ein detaillierter ausgeführtes Ausführungsbeispiel des erfindungsgemäßen Leistungsverstärkers gemäß FIG. 12 mit dreiphasig ausgeführten Verstärkermoduln gemäß FIG. 4 |
| FIG. 14 | eine erste Abwandlung des erfindungsgemäßen Leistungsverstärkers gemäß FIG. 13 mit jeweils einem Koppelkondensator in den durchgehenden Verbindungsleitungen der einzelnen Moduln |
| FIG. 15 | eine zweite Abwandlung des erfindungsgemäßen Leistungsverstärkers gemäß FIG. 13 mit jeweils einem Sperrkreis in den durchgehenden Verbindungsleitungen der einzelnen Moduln |
| FIG. 16 | ein detaillierter ausgeführtes weiteres Ausführungsbeispiel des erfindungsgemäßen Leistungsverstärkers gemäß FIG. 12 mit Verstärkermoduln gemäß FIG. 5 |
| FIG. 17 | eine dritte Abwandlung des erfindungsgemäßen Leistungsverstärkers gemäß FIG. 13 mit einem zusätzlich nachgeschalteten Tiefpaßfilter |
| FIG. 18 | ein Ersatzschaltbild im Ausschnitt für den erfindungsgemäßen Leistungsverstärker gemäß FIG. 13 mit den Filterkondensatoren und den integrierten Transformatorkapazitäten |
| FIG. 19 | ein Ersatzschaltbild im Ausschnitt für den erfindungsgemäßen Leistungsverstärkers gemäß FIG. 13 zur Berechnung der Ersatzkapazität $C_N$ der Kapazitäten der integrierten Tiefpaßfilter |
| FIG. 20 | ein Detail einer vorteilhaften Ausführungsform des verwendeten Drehstrom-Netztransformators mit den sekundärseitigen Herausführungen für zwei Verstärkermoduln über einen Stützer |
| FIG. 21 und FIG. 22 | einen Stützer gemäß FIG.20 in der Seitenansicht (FIG. 21) und in der Draufsicht (FIG. 22). |

Der erfindungsgemäße Leistungsverstärker in FIG. 4 besteht, wie die Ersatzschaltbilder dieser Schaltung in den FIG. 8 und 9 zeigen, aus zwei zu einem Verstärkermodul V zusammengefaßten Einzelverstärkern, die jeweils aus einem aus Gleichspannungsnetzgerät UB1 bzw. UB2, Schalter SCH1 bzw. SCH2 und Freilaufdiode

EP 0 349 743 B1

FD1 bzw. FD2 aufgebauten sekundärseitig geschalteten Schaltverstärker sowie aus einem aus Filterspule FL1 bzw. FL2 und Filterkondensator FC1 bzw. FC2 aufgebauten Tiefpaßfilter bestehen.

Erfindungsgemäß sind in diesem Verstärkermodul V sowohl die Gleichspannungsnetzgeräte UB1 und UB2 und die Freilaufdioden FD1 und FD2 der beiden Schaltverstärker als auch die Filterkondensatoren FC1 und FC2 der beiden Tiefpaßfilter jeweils in Reihe geschaltet und die Verbindungspunkte P2, P5 und P8 zwischen den jeweiligen Bauelemente-Paaren dieser drei Reihenschaltungen über eine durchgehende Verbindungsleitung VL miteinander verbunden. Die äußeren Endpunkte P3, P6, P9 bzw. P4, P7, P10 dieser drei Reihenschaltungen sind jeweils über eine weitere Reihenschaltung aus Schalter SCH1 bzw. SCH2 und Filterspule FL1 bzw. FL2 miteinander verbunden, wobei die Reihenschaltung der Freilaufdioden FD1 und FD2 mit ihren beiden Endpunkten P6 bzw. P7 jeweils zwischen Schalter SCH1 bzw. SCH2 und Filterspule FL1 bzw. FL2 angeschlossen ist.

Die Reihenschaltung der beiden Gleichspannungsnetzgeräte UB1 und UB2 ist in diesem Verstärkermodul V in Form eines an sich bekannten und beispielsweise im TELEFUNKEN Röhrentaschenbuch, Ausgabe 1956, auf Seite 310 beschriebenen Doppelnetzgeräts realisiert.

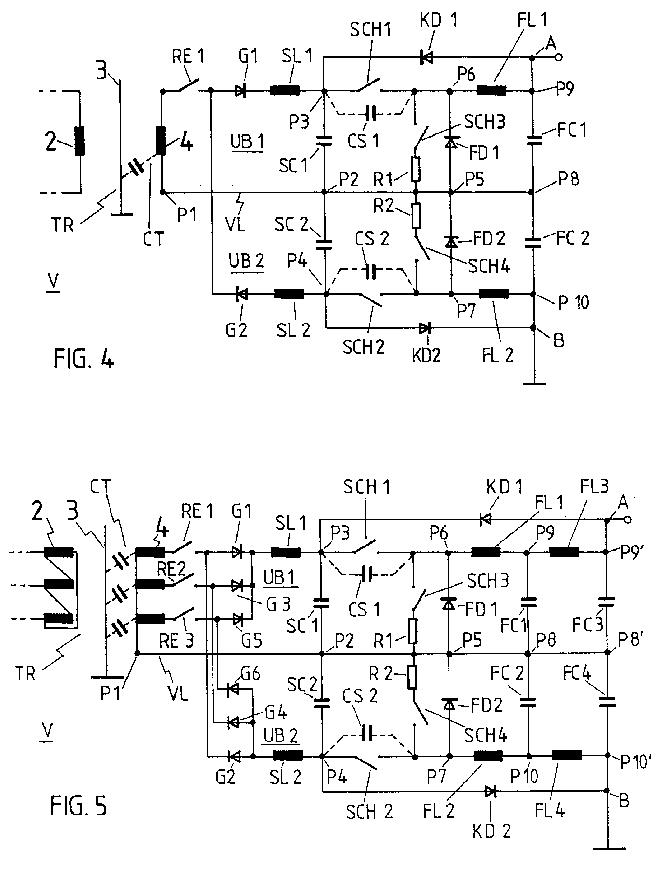

Dieses Doppelnetzgerät enthält einen Netztransformator TR, der in dem Ausführungsbeispiel in FIG. 4 beispielhaft einphasig mit einer Primärwicklung 2 und einer Sekundärwicklung 4 ausgeführt ist und der zur Ableitung kapazitiver Schaltströme eine an Masse angeschlossene Schirmung 3 enthält.

In dieser wie auch in den folgenden Figuren sind der Übersichtlichkeit wegen keine weiteren Details im Aufbau des verwendeten Transformators (Eisenkern, Isoliermaterialien usw.) enthalten, die aber dennoch bei der konkreten Realisierung sehr wohl zu berücksichtigen sind.

An das eine Ende der Sekundärwicklung sind zwei gegenpolig geschaltete Gleichrichter G1 und G2 angeschlossen, die bezüglich des anderen Endes P1 der Sekundärwicklung zwei Roh-Gleichspannungen mit unterschiedlicher Polarität erzeugen, die in dem jeweils nachgeschalteten LC-Siebglied, bestehend aus Siebdrossel SL1 bzw. SL2 und Siebkondensator SC1 bzw. SC2, gesiebt, d.h. geglättet werden. Die Siebkondensatoren SC1 und SC2 sind bei diesem Doppelnetzgerät in Reihe geschaltet, wobei ihr gemeinsamer Verbindungspunkt P2 über die durchgehende Verbindungsleitung VL mit dem anderen Ende P1 der Sekundärwicklung 4 verbunden ist.

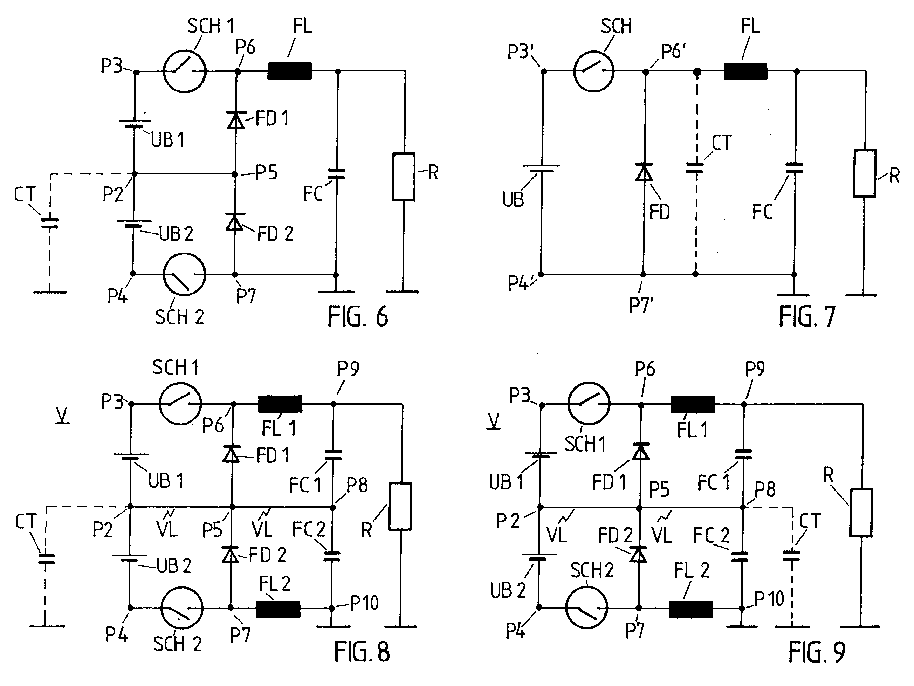

Die an dem jeweiligen Siebkondensator SC1 bzw. SC2 anliegende geglättete Gleichspannung stellt dabei die Ausgangsspannung des jeweiligen Gleichspannungsnetzgerätes UB1 bzw. UB2 in den Figuren 8 oder 9 dar, sodaß die Anschlußpunkte P3, P2 bzw. P4 der Siebkondensatoren SC1 bzw. SC2 in FIG. 4 identisch sind mit den Anschlußpunkten P3, P2 bzw. P4 der beiden in Reihe geschalteten Gleichspannungsnetzgeräte UB1 bzw. UB2 in FIG. 8 oder 9.

Mit dem symmetrischen Aufbau des erfindungsgemäßen Verstärkermoduls V mit der durchgehenden Verbindungsleitung VL als "Symmetrieachse" ist im erfindungsgemäßen Verstärkermodul V eine durchgehende symmetrische Verbindung vorhanden zwischen der Sekundärwicklung 4 des Netztransformators (TR) einerseits und den Filterkondensatoren FC1 bzw. FC2 der Tiefpaßfilter andererseits, wodurch insbesondere die sekundärwicklungsbedingten Aufbaukapazitäten des Netztransformators TR direkt mit den Tiefpaßfiltern verbunden und in diese "integriert" sind.

Die Schirmkapazität CT zwischen der Sekundärwicklung 4 und der an Masse liegenden Schirmung 3 beispielsweise, die einen wesentlichen Anteil dieser schädlichen Aufbaukapazitäten darstellt und die in der FIG. 4 gestrichelt eingezeichnet ist, ist im vereinfachten Ersatzschaltbild gemäß FIG. 8 mit einem Ende an Masse und (wegen der direkten Verbindung der Punkte P1 und P2 in FIG. 4) mit dem anderen Ende an den Verbindungspunkt P2 der beiden in Reihe geschalteten Gleichspannungsnetzgeräte UB1 und UB2 angeschlossen.

Äquivalent hierzu ist wegen der direkten symmetrischen Verbindung VL der Verbindungspunkte P2 und P8 das in FIG. 9 gezeigte Ersatzschaltbild der FIG. 4, in dem die Schirmkapazität CT parallel zum Filterkondensator FC2 geschaltet ist und damit einen integralen Bestandteil des entsprechenden Tiefpaßfilters FL2, FC2 bildet.

Der große Vorteil dieser erfindungsgemäßen Schaltung besteht darin, daß mit dieser Integration insbesondere der sekundärwicklungsbedingten Aufbaukapazitäten des Netztransformators in die Tiefpaßfilter an dem Transformator nicht mehr, wie bei den bekannten Leistungsverstärkern, die hohen Abtast- bzw. Schaltfrequenzen anliegen, sondern nur noch das abzutastende niederfrequentere Eingangssignal, so daß die schädlichen Aufbaukapazitäten nur noch mit der Frequenz des Eingangssignals (und nicht mehr mit der Schaltfrequenz) umgeladen werden, was mit einer entsprechenden Reduzierung der Verlustleistung in den Aufbaukapazitäten des Netztransformators bzw. mit einer entsprechenden Verbesserung des Wirkungsgrades des Leistungsverstärkers verbunden ist.

Ein qualitativer Vergleich des erfindungsgemäßen Leistungsverstärkers mit einem beispielsweise aus der DE-A1-36 35 365 oder der EP-A1-0 066 904 bekannten Leistungsverstärkers mag diesen Sachverhalt anhand der Ersatzschaltbilder dieser beiden Verstärker in den Figuren 8 und 9 bzw. 6 und 7 verdeutlichen.

5

Der bekannte Schaltverstärker verwendet ebenfalls das an sich bekannte Doppelnetzgerät, um damit aber, wie FIG. 6 zeigt, zwei in Reihe geschaltete Schaltverstärker UB1, SCH1, FD1 bzw. UB2, SCH2, FD2 zu realisieren, denen ein gemeinsames Tiefpaßfilter FL, FC nachgeschaltet ist.

Da bei dieser Schaltung die durchgehende symmetrische Verbindung zwischen Sekundärwicklung des Netztransformators und dem Tiefpaßfilter fehlt, liegt in dem Fall, wie das bei synchron angesteuerten Schaltern SCH1 und SCH2 hierzu äquivalente Ersatzschaltbild mit einem Netzgerät UB (der doppelten Ausgangsspannung), einem Schalter SCH und einer Freilaufdiode FD in FIG. 7 zeigt, die schädliche Schirmkapazität CT nicht mehr parallel zum Filterkondensator FL, sondern parallel zur Freilaufdiode FD und wird daher im Takt der weitaus höheren Schaltfrequenz umgeladen, was mit einer entsprechenden Verschlechterung des Wirkungsgrades des Leistungsverstärkers einhergeht.

In FIG. 5 ist ein weiteres besonders vorteilhaftes Ausführungsbeispiel des erfindungsgemäßen Verstärkermoduls V gezeigt, das sich von der in FIG. 4 gezeigten Schaltung dadurch unterscheidet,

- daß anstelle des einphasig ausgeführten Netztransformators hier ein primärseitig im Dreieck und sekundärseitig im Stern P1 geschalteter Drehstrom-Netztransformator vorgesehen ist, dem sekundärseitig zwei gegenpolig geschaltete Drehstrom-Stern-Gleichrichterschaltungen G1, G3, G5 bzw. G2, G4, G6 nachgeschaltet sind und bei dem der Verbindungspunkt P2 der in Reihe geschalteten Siebkondensatoren SC1 und SC2 mit dem Sternpunkt P1 der Sekundärwicklungen 4 direkt verbunden ist und
- daß anstelle der einstufig ausgeführten Tiefpaßfilter hier beispielhaft zweistufig ausgeführte Tiefpaßfilter FL1, FC1; FL3, FC3 bzw. FL2, FC2; FL4, FC4 vorgesehen sind, die für eine noch stärkere Dämpfung der Schaltfrequenz und ihrer Oberschwingungen, d.h. für eine noch geringere Verzerrung der Verstärkerausgangsspannung sorgen.

In dem der FIG. 9 entsprechenden Ersatzschaltbild dieser Schaltung wären die Schirmkapazitäten zwischen den einzelnen Sekundärwicklungen 4 und der Schirmung 3 in FIG. 5 parallel zu dem Filterkondensator FC4 der zweiten Filterstufe FL4, FC4 des unteren Tiefpaßfilters geschaltet und zu einer gemeinsamen Schirmkapazität CT zusammengefaßt.

Die Schalter SCH1 bzw. SCH2 des erfindungsgemäßen Verstärkermoduls V in den FIG. 4 oder 5 können unabhängig voneinander angesteuert, d.h. ein- und ausgeschaltet werden. Die von dem Eingangssignal abgeleiteten Impulsfolgen legen dabei die zeitliche Abfolge der Schaltimpulse fest. Die resultierende Ausgangsspannung $U_A$ am Ausgang des Verstärkermoduls V kann im Idealfall in Abhängigkeit von diesen Impulsfolgen bzw. den Schaltimpulsen statisch oder dynamisch jede beliebigen Wert zwischen 0 Volt (beide Schalter ausgeschaltet) und $2U_B$ (beide Schalter eingeschaltet) annehmen, wobei $U_B$ die Ausgangsspannung eines Gleichspannungsnetzgerätes UB1 oder UB2 ist.

Vorteilhafterweise werden die beiden Schalter SCH1 bzw. SCH2 des erfindungsgemäßen Verstärkermoduls V jedoch synchron, d.h. zeitgleich angesteuert, beispielsweise mit pulsfrequenzmodulierten Impulsfolgen mit konstanter Impulsdauer $t_{on}$=const. oder vorzugsweise mit pulsdauermodulierten Impulsfogen, da in diesem Fall die Schaltung in FIG. 5 wie eine Drehstrom-Brückenschaltung wirkt, die es erlaubt, die an sich schädlichen Aufbaukapazitäten des Netzformators durch Integration in die Tiefpaßfilter unschädlich zu machen und die gleichzeitig den guten Wirkungsgrad einer Drehstrom-Brückenschaltung aufweist.

Bei konstantem Lastwiderstand R ändern sich bei Ansteuerung des erfindungsgemäßen Verstärkermoduls V mit pulsdauermodulierten Impulsfolgen theoretisch die Ausgangsspannung $U_A$ und der Ausgangsstrom linear mit dem Tastverhältniswert $V_T$, d.h. mit dem Verhältnis zwischen Einschaltzeit $T_{EIN}$ der sychron angesteuerten Schalter SCH1 und SCH2 und Periodendauer T der Schaltschwingung. In der Praxis gilt dieser lineare Zusammenhang jedoch nicht. Die tatsächliche Ausgangsspannung $U_A$ weicht mit abnehmenden Tastverhältniswert $V_T$ zunehmend von dem theoretischen Wert ab, so daß sich im Bereich kleiner Eingangssignalamplituden bzw. schmaler Schaltimpulse in der Ausgangsspannung $U_A$ sogenannte "Unterstrichverzerrungen" ergeben.

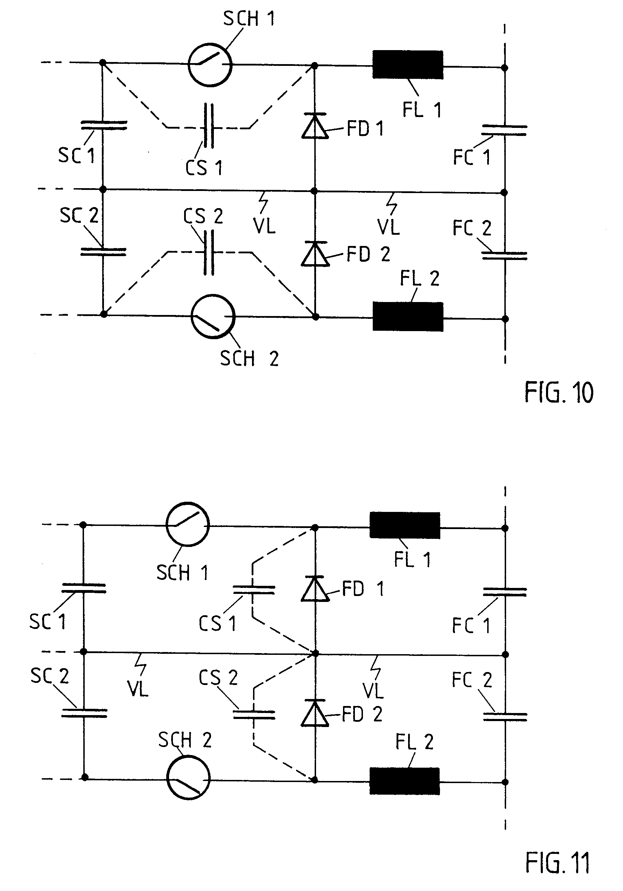

Diese Unterstrichverzerrungen entstehen durch die Auf- und Entladung unerwünschter Schaltkapazitäten CS an der mit Schaltimpulsen beaufschlagten Seite der Filterspulen FL1 und FL2. Diese Schaltkapazitäten sind im wesentlichen die Ausgangskapazitäten CS1 und CS2 der verwendeten Schalter SCH1 und SCH2, die im Prinzip parallel zu den zugehörigen Schalter geschaltet sind, wie dem in FIG. 10 im Ausschnitt gezeigten Ersatzschaltbild für die FIG. 4 zu entnehmen ist.

Da jedoch die Kapazität der beiden Siebkondensatoren SC1 bzw. SC2 sehr groß ist und diese somit für die Schaltschwingung einen Kurzschluß darstellen, liegen die Ausgangskapazitäten CS1 bzw. CS2 der beiden Schalter SCH1 bzw. SCH2 in Wirklichkeit parallel zu der jeweiligen Freilaufdiode FD1 bzw. FD2, wie dem in FIG. 11 im Ausschnitt gezeigten Ersatzschaltbild für die FIG. 10 zu entnehmen ist.

Diese Kapazitäten CS1 bzw. CS2 werden beim Schließen der Schalter SCH1 bzw. SCH2 auf $U_B$ aufgeladen und nach dem Öffnen der Schalter durch den durch die Filterspulen FL1 bzw. FL2 fließenden Strom entladen. Erst nach vollständiger Entladung der "Kondensatoren" CS1 und CS2 fließt der Strom in gewünschter Weise durch die Freilaufdioden FD1 und FD2. Die Entladezeit ist dabei umgekehrt proportional zum Strom, so daß sich dieser störende Effekt vor allem bei kleinen Stromwerten in Form der oben beschriebenen Unterstrichverzerrungen bemerkbar macht.

Zur Reduzierung dieser Unterstrichverzerrungen sind in einer vorteilhaften Weiterbildung der bisher diskutierten Grundschaltung des erfindungsgemäßen Verstärkermoduls V in den Schaltungen der FIG. 4 und 5 den beiden Freilaufdioden FD1 und FD2 jeweils eine Reihenschaltung aus Widerstand R1 bzw. R2 und weiterem Schalter SCH3 bzw. SCH4 parallel geschaltet, die im Gegentakt zu den beiden "Hauptschaltern" SCH1 und SCH2 arbeiten und die für die Entladung der Schaltkapazitäten CS1 und CS2 sorgen.

Vorteilhafterweise ist zwischen Öffnen (Schließen) der Hauptschalter SCH1 und SCH2 und Schließen (Öffnen) der "Entladeschalter" SCH3 und SCH4 jeweils eine Verzögerungs- bzw. Totzeit vorgesehen, deren Dauer vorzugsweise in etwa den Entladezeiten der Schaltkapazitäten CS1 und CS2 für große Stromwerte, d.h. bei Oberstrich und Strich entspricht, so daß bei Oberstrich und Strich die Umladeleistung über den Lastwiderstand R abfließt und nur bei Unterstrich in den Entladewiderständen R1 und R2 verbraucht wird.

Da in dieser Zeit aber nur geringe Entladeströme fließen, wird der Wirkungsgrad des Verstärkermoduls durch diese Maßnahme nur unerheblich verschlechtert bei gleichzeitig erheblichen Verbesserungen der Qualitätswerte des Ausgangssignals (ge ringerer Verzerrungsgrad). Zur Optimierung ist es vorteilhaft, die Verzögerungszeit zwischen Öffnen (Schließen) der Hauptschalter SCH1 bzw. SCH2 und Schließen (Öffnen) der Entladeschalter SCH3 und SCH4 in Abhängigkeit von den Stromwerten variabel zu machen, so daß als Entladeschalter Schalter kleinerer Schaltleistung (und i.a. entsprechend kürzeren Schaltzeiten) eingesetzt werden können.

Zur Realisierung der Schalter ist in Abhängigkeit von der zu schaltenden Spannung bzw. den zu schaltenden Strom entweder ein einzelner Schalter oder mehrere in Reihe und/oder parallel geschaltete Schalter vorzusehen.

Als Schalter werden vorzugsweise Halbleiterschalter eingesetzt. Von den derzeit verfügbaren Bauelementen kommen dafür in Frage MOS-Feldeffekttransistoren (MOSFET), Static-Induction-Transistoren (SIT), Static-Induction-Thyristoren (SITh), Abschaltthyristoren (GTO), Kaskade- oder Kaskode-Schaltungen usw.

Aus dieser Reihe von Bauelemente-Arten ist jedoch der MOSFET z.Z. am günstigsten, da sich mit ihm sehr kurze Schaltzeiten (und damit sehr geringe Schaltverlüste) erzielen lassen. Außerdem entfallen bei ihm die für die bipolare Bauelemente typischen Speicherzeiten. Ferner ist die Parallelschaltung mehrerer MOSFETs unproblematisch, da ihr Durchlaßwiderstand im Gegensatz zu dem von Bipolartransistoren einen positiven Temperaturkoeffizienten aufweist, der dazu führt, daß der Durchlaßwiderstand eines MOSFETs mit steigender Temperatur zunimmt und der Durchlaßstrom entsprechend abnimmt, so daß sich der zu führende Gesamtstrom automatisch gleichmäßig auf die parallel geschalteten MOSFETs aufgeteilt und eine Überlastung einzelner MOSFET dadurch verhindert wird.

Um bei Lastabwurf, d.h. bei Unterbrechung der Verbindung zum Lastwiderstand, die nunmehr ungedämpften Tiefpaßfilter in dem erfindungsgemäßen Verstärkermodul V an dem Punkt A in den FIG. 4 und 5 nicht auf die doppelte Ausgangsspannung $2U_A$ schwingen zu lassen, ist in einer weiteren vorteilhaften Weiterbildung der erfindungsgemäßen Grundschaltung jeweils eine Kappdiode KD1 bzw. KD2 vom Verstärkerausgang A bzw. B zum Ausgang P3 bzw. P4 des zugeordneten Gleichspannungsnetzgeräts UB1 bzw. UB2 geschaltet, die diese Überschwinger in den Spannungen "klemmt", d.h. abschneidet. Die Dioden KD1, KD2 brauchen nicht sehr schnell zu sein, d.h. $t_{rr}$ kann groß sein. Sie müssen nur die Schwingungen bei der Resonanzfrequenz der Tiefpaßfilter (die im Anwendungsfall als Modulationsverstärker für einen Sender im kHz-Bereich liegt) kappen können.

Zur Abschaltung des gesamten Verstärkermoduls V z.B. in Störfällen kann in einer vorteilhaften Weiterbildung der erfindungsgemäßen Grundschaltung in den Schaltungen der FIG. 4 und 5 der Netztransformator TR durch Leistungs-Schutzrelais RE1-RE3 oder durch Schütze von der übrigen Schaltung getrennt werden.

Bis hierher wurde die erfindungsgemäße Lösung am Beispiel eines einzigen erfindungsgemäßen Verstärkermoduls V anhand der Figuren 4-11 näher beschrieben und die sich daraus ergebenden prinzipiellen Vorteile erläutert.

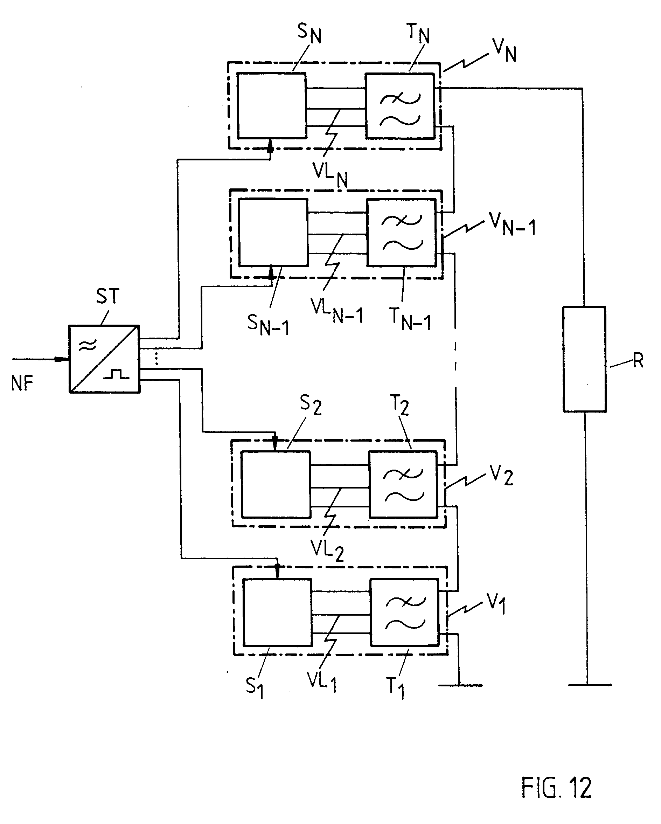

Diese Vorteile treten jedoch noch deutlicher zu Tage, wenn man zur Erzeugung hoher Ausgangsspannungen (beispielsweise zur Modulation einer RF-Endstufe eines Hochleistungssenders) mehrere dieser erfindungsgemäßen Verstärkermoduln V, die ja in sich bereits komplette Leistungsverstärker sind, ausgangsseitig in Reihe schaltet, wie dies anhand der Figuren 12-22 im folgenden näher erläutert werden soll.

Der erfindungsgemäße Leistungsverstärker gemäß FIG. 12 besteht aus mehreren ausgangsseitig in Reihe geschalteten kompletten Verstärkermoduln $V_1$-$V_N$ gemäß FIG. 4 oder 5, die jeweils aus einem sekundärseitig geschalteten Schaltverstärkerteil $S_1$-$S_N$ und einem nachgeschalteten Tiefpaßfilterteil $T_1$-$T_N$ bestehen, wobei die Schaltverstärkerteile $S_1$-$S_N$ jeweils über drei Verbindungsleitungen mit dem zugehörigen Tiefpaßfilterteil $T_1$-$T_N$ verbunden sind, nämlich den beiden äußeren Verbindungsleitungen und der erfindungsgemä-

ßen "symmetrischen" mittleren Verbindungsleitung $VL_1$-$VL_N$.

Die Ansteuerung der einzelnen Schaltverstärker erfolgt über eine Steuerschaltung ST, in der aus dem analogen Eingangssignal, hier beispielhaft dem modulierenden Niederfrequenz-Signal NF, die zur Ansteuerung erforderlichen Impulsfolgen, hier beispielhaft phasensynchron pulsdauermodulierte Impulsfolgen, gebildet werden. Als Last ist beispielhaft ein ohmscher Widerstand R angenommen, der in der Anwendung des erfindungsgemäßen Leistungsverstärkers als Modulationsverstärker für einen amplitudenmodulierten Hochleistungssender stellvertretend für die anodenmodulierte RF-Endstufe steht.

In diesem Anwendungsbeispiel eines Modulationsverstärkers für einen anodenmodulierten Hochleistungssender sind die einzelnen Verstärkermoduln $V_1$-$V_N$ somit komplette NF-Verstärkermoduln, die ausgangsseitig das um einen bestimmten Faktor verstärkte und mit einem der Trägerleistung anteilmäßig entsprechenden Gleichspannungsanteil versehene analoge NF-Eingangssignal abgeben und deren Reihenschaltung durch Aufsummierung dieser phasensynchron verstärkten NF-Eingangssignale die NF-modulierte Betriebsgleichspannung für die in Reihe mit dem Modulationsverstärker geschaltete anodenmodulierte RF-Endstufe liefert.

Da die Schaltverstärker $S_1$-$S_N$ (bzw. die in Reihe geschalteten Gleichspannungsnetzgeräte UB1 und UB2) sämtlicher Verstärkermoduln $V_1$-$V_N$ theoretisch gleichzeitig, in der Praxis mehr oder minder gleichzeitig, ein- und ausgeschaltet, wirkt der erfindungsgemäße Leistungsverstärker ausgangsseitig wie ein Konventioneller Pulsdauermodulationsverstärker ("PDM-Verstärker"), der nur ein von einer pulsdauermodulierten Impulsfolge angesteuertes Schaltelement (i.a. eine Schaltröhre) enthält.

Wird ein solcher PDM-Verstärker als Modulationsverstärker eines anodenmodulierten Hochleistungs-Senders eingesetzt, wird die Modulation durch periodisches Schalten ("Zerhacken") der Betriebsgleichspannung der RF-Endstufe erzeugt, wobei die Dauer der Schaltimpulse proportional zur jeweiligen Amplitude des modulierenden NF-Signals ist. Die Schaltfrequenz muß dabei größer sein wie die maximal zulässige Frequenz des modulierenden NF-Signals (nach dem Abtasttheorem mindestens doppelt so groß) und kleiner sein als die niedrigste, in der RF-Stufe erzeugte Trägerfrequenz.

Im Gegensatz zu dem in der DE-A1-30 44 956 und der EP-A1-0 066 904 beschriebenen Steuerverfahren, bei dem mit Hilfe der in Reihe geschalteten Schaltverstärker das analoge Eingangssignal in quantisierter Form verstärkt wird ("PSM-Verfahren"), arbeitet das PDM-Steuerverfahren ("PDM-Verfahren") kontinuierlich, d.h. die Breite bzw. Dauer der Schaltimpulse am Ausgang eines PDM-Verstärkers ändert sich kontinuierlich mit dem Augenblickswert des analogen Eingangssignals, so daß bei letzterem Verfahren die aufgrund der Quantisierung auftretenden Schwierigkeiten in Bezug auf die Einhaltung der geforderten Qualitätswerte eines Senders (Klirrfaktor, Rauschen, Randaussendungen etc....) stark gemindert werden.

Jedoch ist die Schalthäufigkeit der Schalter beim "PDM-Verfahren" i.a. höher als beim "PSM-Verfahren", was in der Vergangenheit eine merklich höhere Schaltverlustleistung und damit einen schlechteren Wirkungsgrad zur Folge hatte. Durch den heute erreichten Entwicklungsstand bei den Leistungshalbleitern (wie z.B. MOS-Feldeffekttransistoren (MOSFET) oder Static-Induction-Thyristoren etc.) ist dieser prinzipielle Nachteil praktisch bedeutungslos geworden, so daß das mit dem PDM-Verfahren einfachere und sichere Erreichen der geforderten Qualitätswerte für die Entwicklung zumindest bei den Hochleistungssendern in Zukunft maßgebend sein wird, da der mit den beiden Steuerverfahren erzielbare Gesamtwirkungsgrad zumindest bei dem erfindungsgemäßen Leistungsverstärker praktisch gleich ist.

Es versteht sich von selbst, daß zur Ansteuerung des erfindungsgemäßen Leistungsverstärkers gemäß FIG. 12 nicht nur das PDM- oder das PSM-Verfahren eingesetzt werden kann, sondern generell jedes beliebige Pulsmodulationsverfahren.

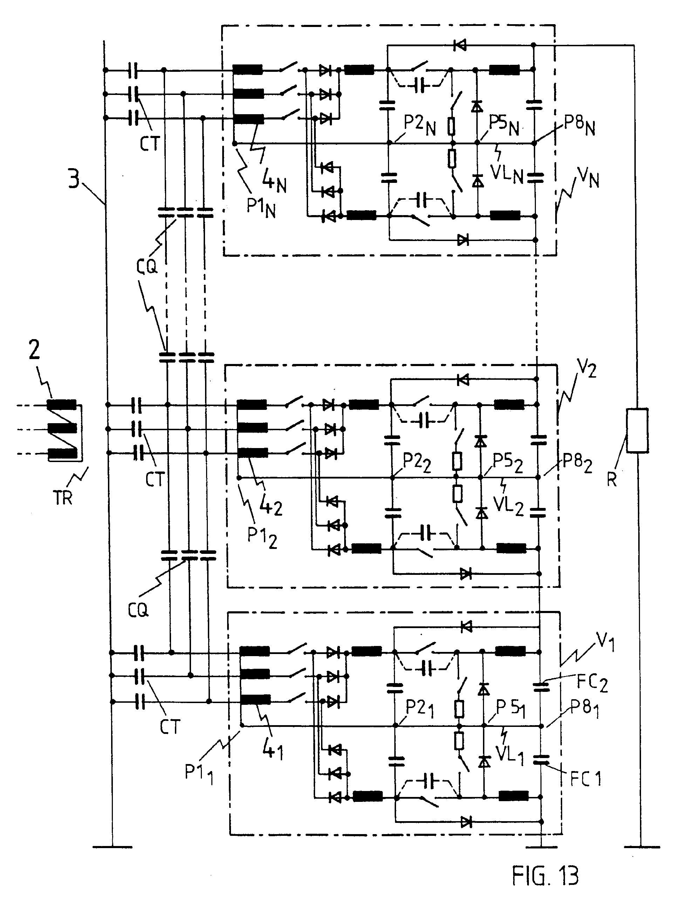

In den Figuren 13-17 sind Ausführungsbeispiele des er findungsgemäßen Leistungsverstärkers gemäß FIG. 12 gezeigt, die sich insbesondere eignen für den Einsatz als Modulationsverstärkers in amplitudenmodulierten Hochleistungssender mit einer anodenmodulierten RF-Endstufenröhre. Die maximale Ausgangsspannung eines solchen Modulationsverstärkers liegt heute im Bereich um 30 kV, seine Nennleistung beträgt i.a. weitaus mehr als 50 kW.

Der Leistungsverstärker in FIG. 13 besteht aus N gleichartigen erfindungsgemäßen Verstärkermoduln $V_1$-$V_N$ gemäß FIG. 4 in dreiphasiger Ausführung, wobei die Netztransformatoren der einzelnen Verstärkermoduln $V_1$-$V_N$ vorteilhafterweise zu einem Netztransformator TR mit einem Satz von im Dreieck geschalteten Primärwicklungen 2 und mit einer der Zahl der Verstärkermoduln entsprechenden Anzahl von Sekundärwicklungssätzen $4_1$-$4_N$ sowie mit einer an Masse liegenden gemeinsamen Schirmung 3 zusammengefaßt worden sind.

Ein Vorteil dieser Lösung gegenüber der aus der DE-A1-35 02 135 bekannten Lösung (vgl. FIG. 1) besteht darin, daß die Zahl der sekundären Transformatorwicklungen durch die Verwendung von Doppelnetzgeräten halbiert ist, so daß schon allein deswegen die Verlustleistungen in den Aufbaukapazitäten des Netztransformators in der Regel geringer ausfallen.

Leistungsreduzierungen des erfindungsgemäßen Verstärkers erfolgen entweder durch zwangsweises Abschalten einzelner Verstärkermoduln durch die Schalter in den Verstärkermoduln selbst oder vorteilhaft durch die jeweils zwischen Transformator TR und Gleichrichterschaltungen (G1-G6 in FIG. 5) angebrachten Leistungs-Schutzrelais (RE1-RE3 in FIG. 5) oder Schütze, da in letzterem Fall auch bei durchlegierten (leitenden) Halbleiterschaltern die betreffenden Moduln abgeschaltet werden können.

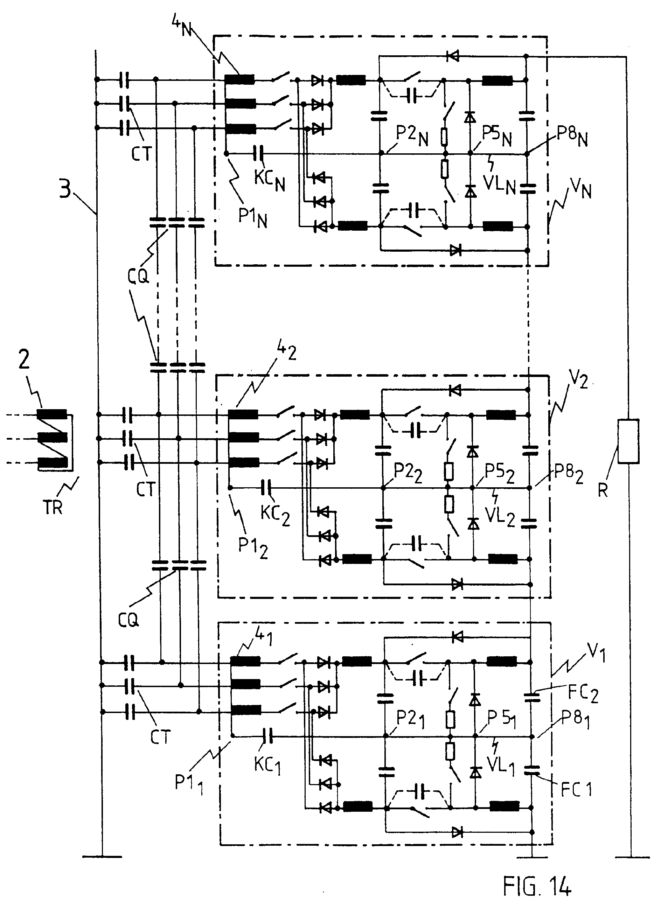

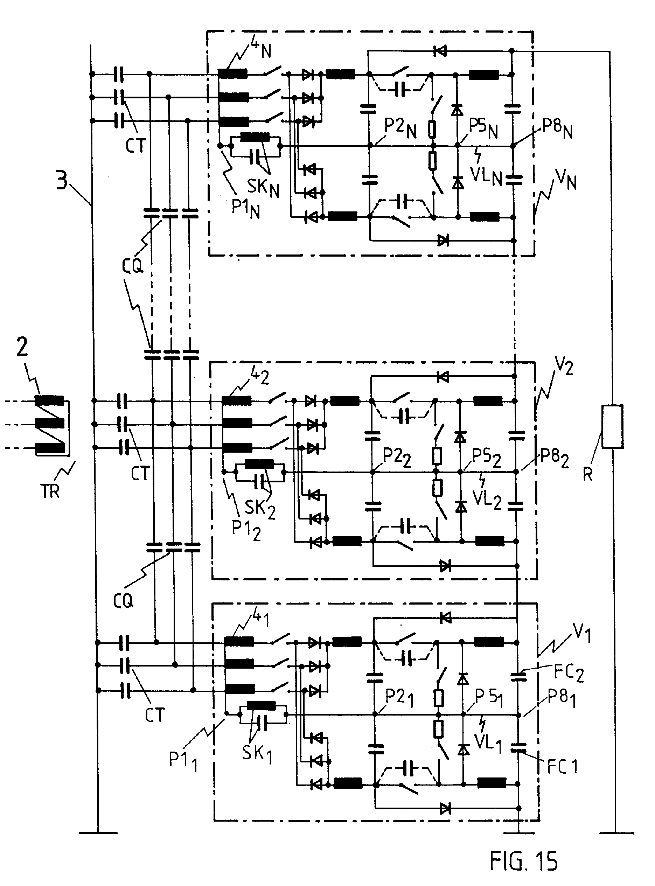

Die Leistungsverstärker in FIG. 14 und 15 unterscheiden sich von dem Verstärker in FIG. 13 dadurch, daß in den durchgehenden Verbindungsleitungen $VL_1$-$VL_N$ der einzelnen Moduln $V_1$-$V_N$ zwischen den Verbindungspunkten $P2_1$-$P2_N$ der in Reihe geschalteten Gleichspannungsnetzgeräte (UB1, UB2 in FIG. 4 oder 5) und den Sternpunkten $P1_1$-$P1_N$ der einzelnen Moduln $V_1$-$V_N$ jeweils ein Koppelkondensator $KC_1$-$KC_N$ (FIG. 14) bzw. ein auf auf die dreifache Netzfrequenz abgestimmter Sperrkreis $SK_1$-$SK_2$ (FIG. 15) angeordnet ist, deren Bedeutung weiter unten erläutert ist.

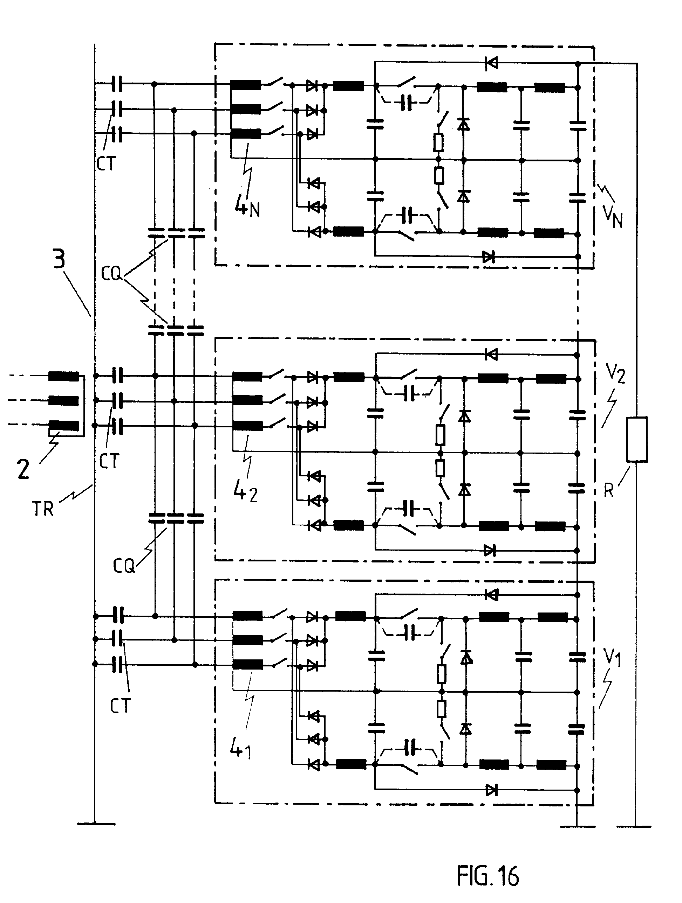

Der Leistungsverstärker in FIG. 16 unterscheidet sich von dem Verstärker in FIG. 13 dadurch, daß die einzelnen Tiefpaßfilter in den Verstärkermoduln $V_1$-$V_N$ gemäß FIG. 5 zweistufig ausgeführt worden sind.

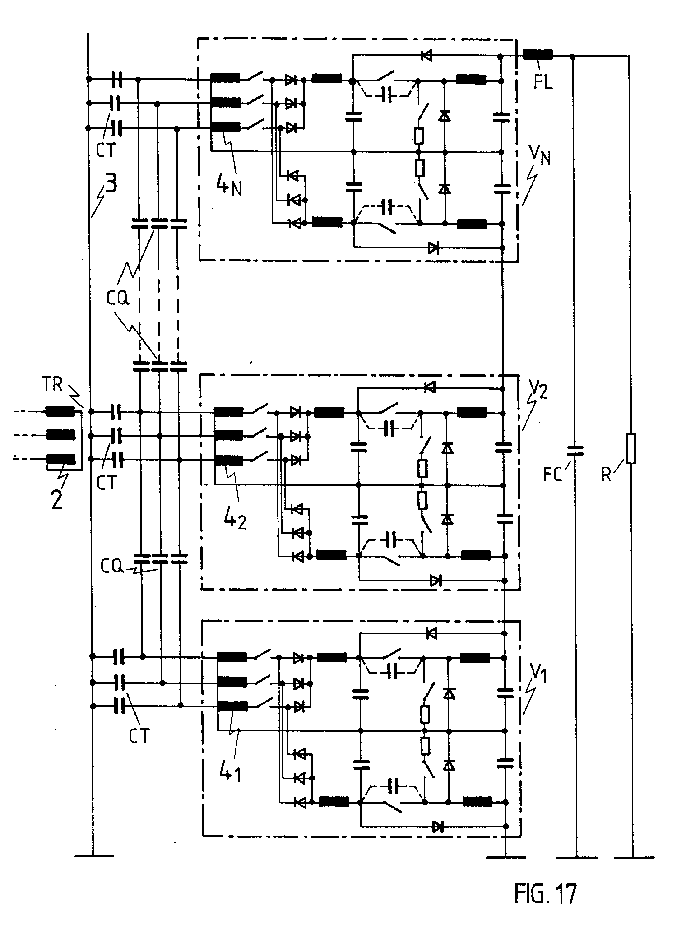

Der Leistungsverstärker in FIG. 17 unterscheidet sich von dem Verstärker in FIG. 13 dadurch, daß ein separates Tiefpaßfilter FL, FC dem Leistungsverstärker nachgeschaltet ist.

In den Figuren 13-17 sind die entsprechenden Schirmkapazitäten CT bzw. Querkapazitäten CQ der Übersichtlichkeit wegen als echte Kondensatoren (mit durchgezogenen Verbindungslinien) und nicht wie in FIG. 3 als aufbaubedingte Kapazitäten (mit gestrichelten Verbindungslinien) gezeichnet. Hiermit soll jedoch nur verdeutlicht werden, daß diese Kapazitäten integrale Bestandteile der nachgeschalteten Tiefpaßfilter in den einzelnen Verstärkermoduln $V_1$-$V_N$ sind. Aus Gründen der Übersichtlichkeit sind außerdem in diesen Figuren keine weiteren Details zum Aufbau des verwendeten Netztransformators (Eisenkern, Isoliermaterialien usw.) enthalten, die aber dennoch bei der Realisierung der erfindungsgemäßen Leistungsverstärker zu berücksichtigen sind.

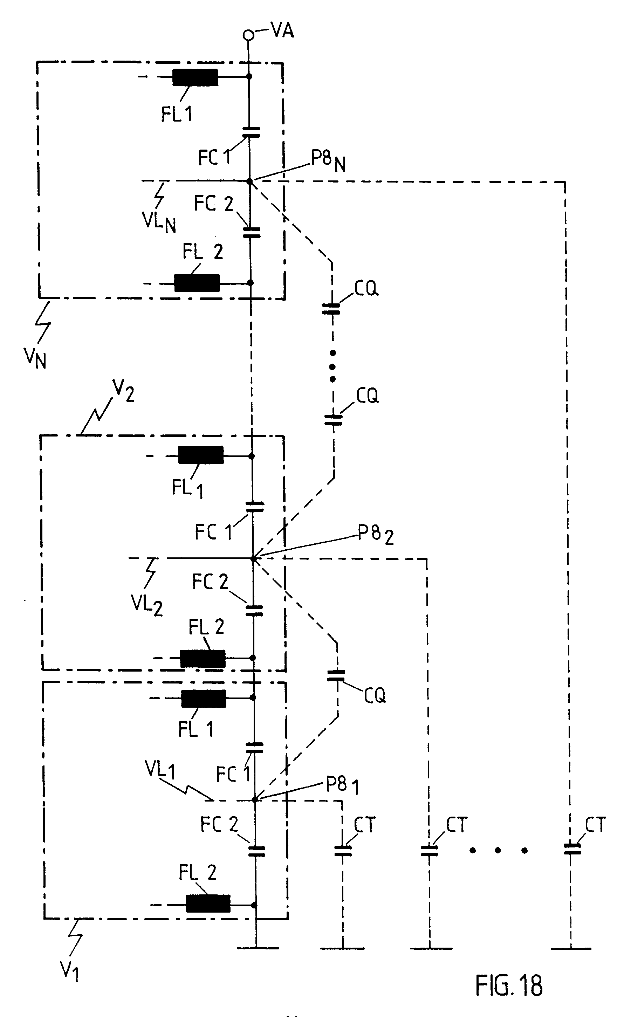

Für den Fall, daß ein erfindungsgemäßer Leistungsverstärker z.B. gemäß FIG. 13 mit gleichartigen Verstärkermoduln gemäß FIG. 4 oder 5 aufgebaut ist, ergibt sich eine einfache Rekursionsformel zur Berechnung der Ersatzkapazität $C_N$, die sich aus den Kapazitäten FC der in Reihe geschalteten Kondensatoren FC1, FC2 der Tiefpaßfilter in den einzelnen Verstärkermoduln ($V_1$-$V_N$) und den hierzu jeweils parallel geschalteten Schirmkapazitäten CT der einzelnen Verstärkermoduln $V_1$-$V_N$ sowie den in Reihe geschalteten Querkapazitäten CQ zwischen räumlich benachbarten Sekundärwicklungen $4_1$-$4_N$ zusammensetzt, wobei die Schirmkapazitäten CT in einem vereinfachten Ersatzschaltbild (FIG. 18) jeweils mit einem Ende an dem gemeinsamen Verbindungspunkt $P8_1$-$P8_N$ der beiden Kondensatoren FC1 und FC2 des entsprechenden Verstärkermoduls $V_1$-$V_N$ und mit dem anderen Ende an Masse angeschlossen sind, während die Querkapazitäten CQ jeweils parallel zu zwei direkt in Reihe geschalteten Filterkondenzatoren FC1 und FC2 zweier benachbarter Verstärkermoduln $V_1$-$V_N$ geschaltet sind, und zwar so, daß sie jeweils an die Verbindungspunkte $P8_1$-$P8_N$ benachbarter Verstärkermoduln $V_1$-$V_N$ angeschlossen sind, wobei mit VA die nicht an Masse liegende Verstärkerausgangsklemme bezeichnet ist.

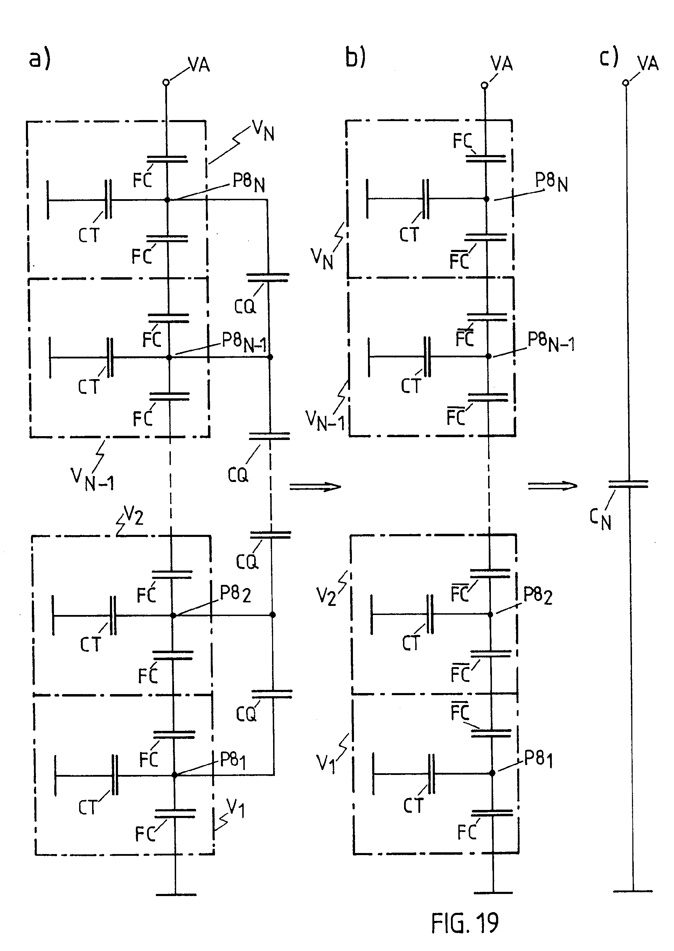

Zur Ableitung der Rekursionsformel sei auf FIG. 19 verwiesen.

FIG. 19a zeigt im wesentlichen das Ersatzschaltbild gemäß FIG. 18 in vereinfachter Form mit den in Reihe geschalteten Filterkondensatoren der Kapazität FC sowie den Schirmkapazitäten CT und den Querkapazitäten CQ der einzelnen Verstärkermoduln $V_1$-$V_N$.

Gemäß FIG. 19b können die einzelnen Querkapazitäten CQ und die ihnen jeweils parallel geschalteten Reihenschaltungen zweier Filterkondensatoren der Kapazität FC jeweils zu einer Reihenschaltung zweier Kondensatoren der Kapazität $\overline{FC}$ zusammengefaßt werden, wobei eine einfache Rechnung ergibt, daß

$$\overline{FC} = FC + 2CQ \quad (1)$$

ist.

Aus FIG. 19b läßt sich nun die Rekursionsformel für die Ersatzkapazität $C_N$ in FIG. 19c ableiten. Ausgehend von einem Anfangswert $C_1$ mit

$$C = \frac{[FC + CT] \cdot \overline{FC}}{[FC + CT] + \overline{FC}} \quad (2)$$

ergibt sich die Rekursionsformel für $C_v$ mit $_v$ = 2....N-1 zu:

$$C_V = \frac{\left[\dfrac{C_{V-1} \cdot \overline{FC}}{C_{V-1} + \overline{FC}} + CT\right] \cdot \overline{FC}}{\left[\dfrac{C_{V-1} \cdot \overline{FC}}{C_{V-1} + \overline{FC}} + CT\right] + \overline{FC}} \qquad (3)$$

und für $C_N$ zu:

$$C_N = \frac{\left[\dfrac{C_{N-1} \cdot \overline{FC}}{C_{N-1} + \overline{FC}} + CT\right] \cdot FC}{\left[\dfrac{C_{N-1} \cdot \overline{FC}}{C_{N-1} + \overline{FC}} - CT\right] + FC} \qquad (4)$$

wobei N die Anzahl der Verstärkermoduln ist.

Der Unterschied in den Formeln (3) und (4) ist darin begründet, daß in der Rekursionsformel (4) für $C_N$ zusätzlich die Filterkapazität FC des Filterkondensators FC1 in dem obersten Verstärkermodul $V_N$ zu berücksichtigen ist, dem keine Querkapazität CQ parallel geschaltet ist (vgl. hierzu FIG. 18 oder 19).

Für einen Leistungsverstärker gemäß FIG. 13 mit dreiphasig ausgeführten Verstärkermoduln gemäß FIG. 4 ergeben sich z.B. mit CF = 3,84 μF und unter Verwendung von Gießharz-Drehstrom-Transformatoren mit CT = 100 pF (d.h. ca. 33 pF pro Sekundärwicklung eines Verstärkermoduls) und CQ = 1500 pF (d.h. ca. 500 pF zwischen zwei benachbarten Sekundärwicklungen eines Schenkels) gemäß den Gleichungen (2) bis (4) folgende Ersatzkapazitäten:

$$
\begin{aligned}
N=1 \qquad &C_1 = 1921 \ \text{nF} \\
N=10 \qquad &C_{10} = 192,5 \ \text{nF} \\
N=20 \qquad &C_{20} = 96,74 \ \text{nF} \\
N=32 \qquad &C_{32} = 61,11 \ \text{nF}
\end{aligned} \qquad (5)
$$

während die Reihenschaltung der Filterkondensatoren FC1, FC2 der einzelnen Verstärkermoduln $V_1$-$V_N$ allein (unter Vernachlässigung der Schirm- und Querkapazitäten) für N=32 eine Gesamt-Ersatzkapazität $C'_{32}$ = 60 nF ergibt, die sich somit nur um etwa 1nF von der zuvor berechneten Ersatzkapazität $C_{32}$ unterscheidet.

Anhand des Ausführungsbeispiels des erfindungsgemäßen Leistungsverstärkers gemäß FIG. 13 mit N = 32 in Reihe geschalteten Verstärkermoduln $V_1$-$V_{32}$ mit einer maximalen Ausgangsspannung von jeweils 1000 Volt, die synchron mit pulsdauermodulierten Impulsfolgen angesteuert werden, sollen im folgenden die Vorteile der erfindungsgemäßen Lösung auch quantitativ verdeutlicht werden.

Unter der Annahme, daß in den einzelnen Verstärkermoduln $V_1$-$V_N$($V_{32}$) des Leistungsverstärkers in FIG. 13 die durchgehende Verbindungsleitung $VL_1$-$VL_N$ ($VL_{32}$) vom Sternpunkt $P1_1$-$P1_N$ nur bis zu dem Verbindungspunkt $P5_1$-$P5_N$ der beiden in Reihe geschalteten Freilaufdioden reichte und das Stück zwischen den Verbindungspunkten $P5_1$ und $P8_1$...$P5_N$ und $P8_N$ fehlte, wären gemäß dem Ersatzschaltbild in FIG. 6 die durch die Schirmung 3 einseitig an Masse angeschlossenen Schirmkapazitäten CT in den einzelnen Verstärkermoduln $V_1$-$V_N$ mit ihren anderen Enden jeweils an den zugehörigen Verbindungspunkt $P2_1$-$P2_N$ angeschlossen und somit nicht in die Tiefpaßfilter integriert (Der Einfachheit halber seien die in Reihe geschalteten Querkapazitäten CQ in FIG. 13 in der folgenden Vergleichsrechnung vernachlässigt).

Für diesen Fall ergibt sich für die in den Schirmkapazitäten CT gespeicherte und bei jedem Schaltvorgang umzuladende Energie $E_V$:

$$E_V = \frac{1}{2} \cdot U \cdot CT \cdot \left[ \frac{1}{3N} (N^2 - \frac{1}{4}) \right] \qquad (6)$$

und für die in den Schirmkapazitäten anfallende Verlustleistung $P_V$:

$$P_V = 2 \, f_S \cdot E_V = f_S \cdot U \cdot CT \cdot \left[ \frac{1}{3N} (N^2 - \frac{1}{4}) \right] \qquad (7)$$

wobei U die Gesamtspannung der N in Reihe geschalteten Verstärkermoduln $V_1$-$V_N$ (hier also U = 32 kV), $f_S$ die Schalt- bzw. "Umlade"frequenz und CT die Schirmkapazität eines Verstärkermoduls ist.

Mit U = 32 kV, CT = 100 pF, N = 32 und $f_s$ = 50 kHz z.B. ergibt sich nach den Gleichungen (6) und (7) für diesen Fall eine Verlustleistung von $P_V$ = 55 kW.

Ist dagegen in den einzelnen Verstärkermoduln $V_1$-$V_N$ ($V_{32}$) des Leistungsverstärkers in FIG. 13 jeweils der Sternpunkt $P1_1$-$P1_N$ der Sekundärwicklungen $4_1$-$4_N$ des Netztransformators TR über die durchgehende Verbindungsleitung $VL_1$-$VL_N$ mit dem Verbindungspunkt $P8_1$-$P8_N$ der Tiefpaßfilter verbunden, oder sind, mit anderen Worten, die Schirmkapazitäten CT der einzelnen Verstärkermoduln $V_1$-$V_N$ erfindungsgemäß in die Tiefpaßfilter integriert, so liegt nicht mehr die hohe Abtast- bzw. Schaltfrequenz $f_s$ von beispielsweise 50 kHz an dem Netztransformator und seinen Aufbaukapazitäten, sondern nur noch das niederfrequentere Eingangssignal.

Bei einem sinusförmigen Eingangssignal ist jedoch nur die durch den Verlustfaktor

$$\tan \delta = P_{Wirk}/P_{Blind} \qquad (8)$$

gegebene Verlustleistung $P_{Wirk}$ wirksam mit:

$$P_{Wirk} = U^2 \cdot w \cdot CT \cdot \tan \delta \cdot \left[ \frac{1}{3N} (N^2 - \frac{1}{4}) \right] \qquad (9)$$

wobei $P_{Blind}$ die Blindleistung, $w$ die Kreisfrequenz des sinusförmigen Eingangssignals, U die Gesamtspannung der N in Reihe geschalteten Verstärkermoduln $V_1$-$V_N$, CT die Schirmkapazität eines Verstärkermoduls und $\tan \delta$ der Verlustfaktor ist.

Mit U = 32 kV, CT = 100 pF, N = 32 und $\tan \delta$ = $5 \cdot 10^{-3}$ (typisch für Gießharztransformatoren) ergibt sich nach Gleichung (9) in diesem Fall für ein 10 kHz-Eingangssignal eine Verlustleistung $P_{Wirk}$ = 350 W, und zwar unabhängig von der Schaltfrequenz.

Im Vergleich zu dem zuvor geschilderten Fall eines vergleichbaren "klassischen" PDM-Verstärkers ohne Integration der Aufbaukapazitäten in die Tiefpaßfilter bedeutet dies eine Reduzierung der anfallenden Verlustleistung um mehr als einen Faktor 150, nämlich von 55 kW auf 0.35 kW.

Dieses Rechnungsbeispiel zeigt deutlich, wie vorteilhaft es ist, die Aufbaukapazitäten der Netztransformatoren bei einem modular aufgebauten Leistungsverstärker, der nach dem PDM-Steuerverfahren arbeitet, auf erfindungsgemäße Weise in die einzelnen Tiefpaßfilter zu integrieren.

Die paarweise ausgangsseitig in Reihe geschalteter Gleichspannungsnetzgeräte (UB1, UB2 in FIG. 4 oder 5) in den einzelnen Verstärkermoduln $V_1$-$V_N$ des Leistungsverstärkers gemäß FIG. 13 sind, wie bereits ausgeführt, sekundärseitig im Stern geschaltet.

Bei der Sternschaltung beträgt jedoch der Effektivwert der Brummspannung bei der dreifachen Netzfrequenz (also bei 150 Hz bei dem i.a. üblichen 50 Hz-Versorgungsnetz) 18,3 % der Ausgangsgleichspannung des Netzgeräts. Die Folge hiervon ist, daß durch den Siebkondensator (SC1 bzs. SC2 in FIG. 4 oder 5) ein Blindwechselstrom der dreifachen Netzfrequenz fließt, der Verluste im Netzgerät verursacht und zudem auch noch die Lebensdauer der üblicherweise als Elektrolytkondensatoren ausgeführten Siebkondensatoren erheblich verkürzt.

Bei einem Gleichspannungsnetzgerät mit einer Ausgangsgleichspannung U = 500 V, das mit einer Siebdrossel mit L = 12 mH und einem Siebkondensator mit C = 4 mF ausgerüstet ist, ergibt sich bei einer 50 Hz - Netzfrequenz ein 150 Hz-Blindwechselstrom

$i_{BLIND}$ von etwa $i_{BLIND} \approx U/w \, L \approx$ 8A (C kann hier vernachlässigt werden).

Dieser Blindwechselstrom wird in dem Leistungsverstärker gemäß FIG. 13 in jeden einzelnen der 2N Gleichspannungsnetzgeräte der N Verstärkermoduln erzeugt, wobei sich die Blindwechselströme der paarweise in Reihe geschalteten Netzgeräte in den einzelnen Verstärkermoduln zudem auch noch zu einem Gesamt-Blindwechselstrom mit im wesentlichen doppelter Amplitude (im Beispiel also 16A) addieren.

Um diesen Blindwechselstrom in den einzelnen Verstärkermoduln zu verringern, kann man, wie in FIG. 14 gezeigt, bei erfindungsgemäßen Leistungsverstärkern, die mit pulsdauer- oder pulsfrequenzmodulierten Impulsfolgen angesteuert werden, in den durchgehenden Verbindungsleitungen $VL_1$-$VL_N$ der einzelnen Verstärkermoduln $V_1$-$V_N$ jeweils zwischen dem Sternpunkt $P1_1$-$P1_N$ und dem Verbindungspunkt $P2_1$-$P2_N$ der in Reihe geschalteten Gleichspannungsnetzgeräte einen Koppel-Kondensator $KC_1$-$KC_N$ schalten. In dem oben angeführten Ausführungsbeispiel eines 500 V-Gleichspannungsnetzgeräts mit L = 12 mH und C = 4 mF ergibt sich mit einem Koppelkondensator der Kapazität C′ = 1 μF ein 150 Hz-Blindwechselstrom $i_{BLIND}$ von etwa

$i_{BLIND} \approx U \cdot \omega\, C' \approx 0,09A$ (L kann vernachlässigt werden), was gegenüber dem ursprünglichen Wert von etwa 8A eine Verringerung um etwa den Faktor 90 bedeutet.

Wie das Beispiel zeigt, führt diese Maßnahme zu vernachlässigbar kleinen Verlusten durch Blindwechselströme bei der dreifachen Netzfrequenz und zu einer spürbaren Entlastung der Siebkondensatoren des erfindungsgemäßen Leistungsverstärkers. Weiterhin ist der Brumm der einzelnen Verstärkermoduln $V_1$-$V_N$ (die Störspannung) geringer und die Spannungskonstanz bei wechselnder Last besser.

Da die Aufbaukapazitäten (Schirm- und Querkapazitäten usw.) des Netztransformators im pF-Bereich liegen, die Koppelkondensatoren dagegen im μF-Bereich, so wird die erfindungsgemäße Integration der Aufbaukapazitäten des Netztransformators in die einzelnen nachgeschalteten Tiefpaßfilter nur unwesentlich durch diese zusätzliche Maßnahme beeinflußt.

Eine andere Möglichkeit, die unerwünschten Blindströme bei der dreifachen Netzfrequenz zu verringern, ist in FIG. 15 gezeigt. Dort ist in den einzelnen Verbindungsleitungen $VL_1$-$VL_N$ jeweils anstelle eines Koppelkondensators ein auf die dreifache Netzfrequenz abgestimmter Sperrkreis $SK_1$-$SK_N$ zwischen Sternpunkt $P1_1$-$P1_N$ und Verbindungspunkt $P2_1$-$P2_N$ eingefügt. Hier hängt das Maß der Verringerung des Blindwechselstroms von der Güte des Sperrkreises ab.

Sind beispielsweise nur 4 Verstärkermoduln $V_1$-$V_4$ zu einem erfindungsgemäßen Leistungsverstärker in Reihe zusammengeschaltet, so kann über die einzelnen Sternpunkte $P_1$-$P_4$ Gleichstrom geführt werden. Die erfindungsgemäße Integration der Aufbaukapazitäten in die einzelnen Tiefpaßfilter erfolgt hier über die Kondensatoren der einzelnen $SK_1$-$SK_N$.

Bei bestimmten Anwendungen kann es vorteilhaft sein, anstelle des bisher diskutierten einstufigen Tiefpaßfilters ein mehrstufiges Tiefpaßfilter, z.B. ein zweistufiges Tiefpaßfilter, zu verwenden. Hier gibt es zwei Möglichkeiten, das Filter erfindungsgemäß zu integrieren. Entweder wird es, wie z.B. in FIG. 16 gezeigt, voll in die einzelnen Verstärkermoduln $V_1$-$V_N$ integriert, wobei in diesem Fall nur die Filterkondensatoren der jeweils letzten Filterstufe der einzelnen Tiefpaßfilter in Reihe zu schalten wären, oder es wird, wie z.B. in FIG. 16 gezeigt, nur ein Teil der Filterstufen integriert und die restlichen Stufen dem Leistungsverstärker nachgeschaltet.

Der Vorteil der ersten Lösung ist vor allem in der vollen Prüfbarkeit der einzelnen Verstärkermoduln zu sehen, während die zweite Lösung vor allem den Vorteil hat, daß sich fertigungstechnische Toleranzen der einzelnen Filterglieder der ersten Stufe praktisch nicht auf die Qualitätswerte des Ausgangssignals des Leistungsverstärkers auswirken können.

Ein weiterer Vorteil des erfindungsgemäßen Leistungsverstärkers gemäß FIG. 13 ergibt sich aus den parallel zu den Freilaufdioden FD1 bzw. FD2 geschalteten Reihenschaltungen aus ohmschem Widerstand R1 bzw. R2 und Schalter SCH3 bzw. SCH 4 in FIG. 4 oder 5. Diese Schalter werden wie bereits diskutiert, im Push-Pull-Betrieb komplementär zu den Hauptschaltern SCH1 bzw. SCH2 betrieben und machen die sonst schädlichen Ausgangskapazitäten CS1 bzw. CS2 der Schalter SCH1 bzw. SCH2 praktisch unwirksam.

Nimmt man z.B. an, daß die Schalter SCH3 und SCH4 mit MOSFET realisiert werden, so treten neben der Eingangskapazität, die i.a. Schwierigkeiten bei der Ansteuerung der Bauelemente verursacht, störende Ausgangskapazitäten auf, die sich aus der Summe aus $C_{DS}$ und $C_{GD}$ (Miller-Kapazität) zusammensetzen und beispielsweise für einen handelsüblichen FET (Siemens BSM 81) typisch 1.3 nF betragen. Schaltet man z.B. fünf dieser MOSFETS parallel, ergibt sich eine Kapazität von etwa 6,5 nF, die sich aufgrund der Aufbaukapazität dieser Schalter SCH1 bzw. SCH2 auf etwa 10 nF insgesamt erhöht.

Diese Kapazität CS (CS1 bzw. CS2 in FIG. 4 oder 5) liegt,wie bereits ausgeführt,in einer ersten Näherung parallel zu der entsprechenden Freilaufdiode (FD1 bzs. FD2 in FIG. 4 oder 5), da die Kapazität des zugehörigen Lade- bzw. Siebkondensators (SC1 bzw. SC2 in FIG. 4 oder 5) sehr groß ist und somit für die Schaltfrequenz $f_S$ einen Kurzschluß bildet. Sind mehrere dieser Verstärkermoduln ausgangsseitig in Reihe geschaltet, sind in einem vereinfachten Ersatzschaltbild die Kapazitäten CS der einzelnen Verstärkermoduln in Reihe geschaltet und addieren sich zu einer Gesamtkapazität von

$$CSG = CS/2N \quad (10)$$

wobei N die Anzahl der Verstärkermoduln ist.

Bei einem Leistungsverstärker z.B. gemäß FIG. 13 mit 32 in Reihe geschalteten Verstärkermoduln gemäß FIG. 4 oder 5 und einer Gesamtspannung U = 32 kV ergibt sich mit CS = 10 nF und $f_S$ = 50 kHz eine Gesamtkapazität CSG = 10 nF:64 = 156 pF und somit eine Schaltverlustleistung von $P_V' = \frac{1}{2}$ CSG·U²·$f_s \approx$ 4 kW.

Unter der Annahme, die Filterdrosseln (FL1 bzw. FL2 in FIG. 4) seien mit I = 100 A bei Oberstrich (positive Amplitude des NF-Signals), I = 50 A bei Träger oder Strich (Ausgangssignal bei Abwesenheit eines NF-Eingangssignals) bzw. I = 2A bei Unterstrich (negative Amplitude des NF-Signals) geladen, so ergeben sich aufgrund der Kapazität CSG die Entladezeiten t für die Filterdrosseln gemäß der Gleichung

$$t = \frac{CSG \cdot U}{I} \quad (11)$$

zu:

$$
\begin{aligned}
&\text{Oberstrich:} && t = 46 \text{ ns} \\
&\text{Träger:} && t = 93 \text{ ns} && (12) \\
&\text{Unterstrich:} && t = 2,34 \text{ μs}
\end{aligned}
$$

Aus den beiden Gleichungen folgt, daß bei Unterstrich, d.h. wenn die PDM-Schaltimpulse sehr schmal werden, signifikante Verzerrungen des Ausgangssignals des Leistungsverstärkers auftreten können.

Diese Verzerrungen werden, wie bereits diskutiert, durch den Einsatz der im Gegentakt zu den Hauptschaltern betriebenen Hilfsschalter (SCH3 bzw. SCH4 in FIG. 4 oder 5) erheblich verringert.

Diese Schalter sind in dem Ausführungsbeispiel gegen die Hauptschalter ca. 100 ns verriegelt, d.h. bei Oberstrich und bei Träger fließt die Umladeleistung über den Lastwiderstand R ab. Nur bei Unterstrich wird die Leistung in den Entladewiderständen (R1, R2 in FIG. 4 oder 5) verbraucht.

Da in dieser Zeit aber nur geringe Entladeströme (hier: I = 2A) fließen, wird der Wirkungsgrad des erfindungsgemäßen Leistungsverstärkers gemäß FIG. 13 durch diese Maßnahme nur unerheblich verschlechtert bei gleichzeitig erheblichen Verbesserungen der Qualitätswert des Ausgangssignals des Leistungsverstärkers (Klirrfaktor usw.). Zur Optimierung ist es auch hier von Vorteil, die Verzögerungszeit zwischen den Schaltänderungen des Haupt- und des zugehörigen Hilfsschalters in Abhängigkeit von den Stromwerten variabel zu machen, damit als Hilfsschalter z.B. MOSFET mit kleinerer Schaltleistung eingesetzt werden können, die i.a. kürzere Schaltzeiten aufweisen als die in den Hauptschaltern zu verwendenden MOSFETs, so daß die durch den Einsatz von Hilfsschaltern verursachte Wirkungsgradverschlechterung hierdurch minimiert werden kann.

Vorteilhaft bei dieser Lösung ist weiterhin, daß das Filter eines gestörten Verstärkermoduls weiterhin wirksam ist.

Die Erfindung kann mit fachmännischem Können und Wissen aus- und weitergebildet werden bzw. an die unterschiedlichen Anwendungen angepaßt werden, ohne daß dies hier an dieser Stelle näher erläutert werden muß.

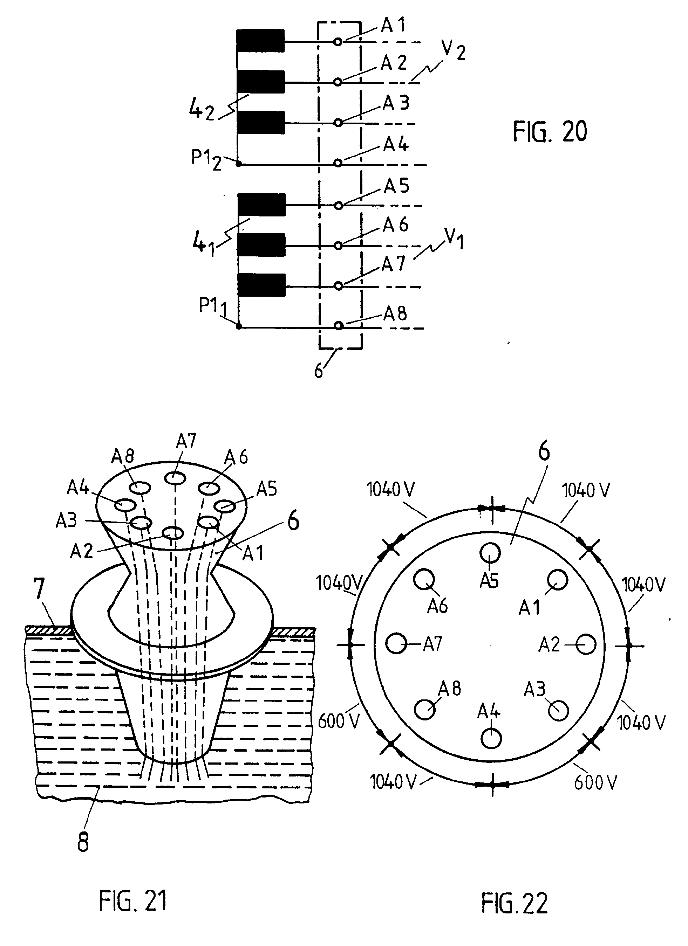

So ist z.B. vorteilhaft, gemäß FIG. 20 die sekundärseitigen Anschlüsse A1-A4 bzw. A5-A8 zweier räumlich benachbarter Sekundärwicklungssätze $4_1$ und $4_2$ des Netztransformators TR gemäß FIG. 13-17 über einen gemeinsamen Stützer 6 aus dem Transformatorgehäuse herauszuführen.

Gemäß FIG. 21 ist ein solcher Stützer 6 z.B. aus Gießharz herstellbar und in die Außenwand 7 eines mit Öl 8 gefüllten Netztransformators einsetzbar. Die Anschlüsse A1 bis A8 entsprechen dabei denjenigen der FIG. 20.

FIG. 22 zeigt eine Aufsicht auf einen Stützer gemäß FIG. 21. Die an dem Außenring angegebenen Spannungsangaben sind beispielhaft gewählte Effektivwerte für Gleichspannungsnetzgeräte (UB1, UB2 in FIG. 4 oder 5), die jeweils Gleichspannungen von ungefähr ± 670 V bezüglich des Verbindungspunktes P2 in FIG. 4 oder 5 erzeugen.

Zur Verringerung der schädlichen Schirmkapazitäten zwischen den Sekundärwicklungen und der Schirmung sind die Sekundärwicklungen des Netztransformators vorteilhaft als sogenannte Kammerwicklungen (vgl. FIG. 3) auszuführen. Aber auch Lagenwicklungen, wobei jede Sekundärwicklung eine Lage bildet, sind denkbar. Allerdings ist in diesem Fall die Kapazitätskonfiguration anders als die bislang diskutierte Konfiguration.

Weiterhin es vorteilhaft, anstelle eines einzigen Drehstrom-Transformators mit N Sekundärwicklungssätzen dieser Art zwei Drehstrom-Transformatoren mit jeweils der Hälfte (N/2) der Sekundärwicklungssätze zu verwenden, von denen vorteilhafterweise der eine einen im Stern geschalteten Primärwicklungssatz und der zweite einen im Dreieck geschalteten Primärwicklungssatz aufweist, so daß fiktiv eine 12-Pulsschaltung mit entsprechend verringertem Netzoberschwingungenanteil vorliegt. Bei Verwendung dieses Prinzips reduziert sich die Zahl der Durchführungen pro Transformator auf N/4, was Vorteile in der Konstruktion solcher Transformatoren mit sich bringt. Alternativ hierzu können auch zwei gleiche Transformatoren mit vertauschten Phasen verwendet werden, die primärseitig in Form eines Polygonzuges mit 15°-Versatz geschaltet sind. Ferner ist es vorteilhaft, die Impulsfolgen zur Ansteuerung der Schalter in den Verstärkermoduln auf optoelektronischem Wege über Lichtwellenleiter zu leiten. Es empfiehlt sich in diesem Fall, die erforderlichen Zusatzstromversorgungen für die Schalter und die Optoelektronik aus der Sekundärspannung des Netz-Transformators (TR in FIG. 4 und 5) zu gewinnen.

Schließlich kann es in manchen Fällen von Vorteil sein, anstelle mehrerer gleichartiger Verstärkermoduln mehrere nicht gleichartige (z.B. in ihren Ausgangsspannungen binär gestufte) Verstärkermoduln zu verwenden.

**Patentansprüche**

1.  Leistungsverstärker zum Verstärken eines analogen Eingangssignals, mit mindestens zwei ausgangsseitig in Reihe geschalteten Einzelverstärkern, welche jeweils aus einem sekundärseitig geschalteten Schaltverstärker und einem nachgeschalteten Tiefpaßfilter bestehen, welcher Schaltverstärker ein an einem Netztransformator (TR) angeschlossenes Gleichspannungsnetzgerät (UB1, UB2), eine hierzu parallel geschaltete Freilaufdiode (FD1, FD2) sowie einen dazwischen geschalteten und durch eine aus dem Eingangssignal abgeleitete Impulsfolge gesteuerten ersten Schalter (SCH1, SCH2) enthält, und welches Tiefpaßfilter eine in Reihe mit dem ersten Schalter geschaltete Filterspule (FL1, FL2) sowie einen der Filterspule nach- und der Freilaufdiode parallel geschalteten Filterkondensator (FC1, FC2) enthält und in seiner oberen Grenzfrequenz so dimensioniert ist, daß an seinem Ausgang das analoge Eingangssignal verstärkt und im wesentlichen unverzerrt anliegt, dadurch gekennzeichnet, daß jeweils zwei direkt hintereinander in Reihe geschaltete Einzelverstärker so zu einem Verstärkermodul zusammengefaßt sind,
    - daß in dem einen Verstärkermodul (V) oder in den mehreren ausgangsseitig in Reihe geschalteten Verstärkermoduln ($V_1$-$V_N$) die Gleichspannungsnetzgeräte (UB1, UB2), die Freilaufdioden (FD1, FD2) sowie die Filterkondensatoren (FC1, FC2) der beiden Einzelverstärker jeweils miteinander in Reihe geschaltet sind;
    - daß die Netztransformatoren der beiden Einzelverstärker zu einem für beide Gleichspannungsnetzgeräte (UB1, UB2) gemeinsamen, vorzugsweise dreiphasig ausgeführten Netztransformator (TR) mit in einem Sternpunkt (P1) zusammengeschalteten Sekundärwicklungen (4) zusammengefaßt sind;
    - daß die Verbindungspunkte (P2, P5, P8) zwischen den in Reihe geschalteten Gleichspannungsnetzgeräten (UB1, UB2), den in Reihe geschalteten Freilaufdioden (FD1, FD2) und den in Reihe geschalteten Filterkondensatoren (FC1, FC2) über eine durchgehende Verbindungsleitung (VL) direkt oder über einen Koppelkondensator oder über einen Sperrkreis mit dem Sternpunkt (P1) verbunden sind;
    - daß die Endpunkte (P3, P6, P9; P4, P7, P10) der drei Reihenschaltungen aus Gleichspannungsnetzgeräten (UB1, UB2), Freilaufdioden (FD1, FD2) und Filterkondensatoren (FC1, FC2) jeweils über eine weitere Reihenschaltung aus Schalter (SCH1, SCH2) und Filterspule (FL1, FL2) miteinander verbunden sind und die Reihenschaltung der Freilaufdioden (FD1, FD2) mit ihren Endpunkten (P6, P7) dabei jeweils zwischen Schalter (SCH1, SCH2) und Filterspule (FL1, FL2) angeschlossen ist.

2.  Leistungsverstärker nach Anspruch 1, dadurch gekennzeichnet, daß bei der Dimensionierung der einzelnen Tiefpaßfilter bezüglich ihrer oberen Grenzfrequenz die als Teile der einzelnen Tiefpaßfilter integrierten Transformatorkapazitäten, insbesondere die Schirmkapazitäten (CT) und/oder Querkapazitäten (CQ), mit einbezogen sind (FIG. 16).

3.  Leistungsverstärker nach Anspruch 2, dadurch gekennzeichnet,
    - daß die beiden Tiefpaßfilter in dem Verstärkermodul (V) jeweils aus mehreren hintereinander geschalteten Filterstufen (FL1, FC1; FL3, FC3 bzw. FL2, FC2; FL4, FC4) bestehen;
    - daß die einzelnen Filterstufen jeweils eine Filterspule (FL1-FL4) und einen der jeweiligen Filterspule nachgeschalteten Filterkondensator (FC1-FC4) enthalten;
    - daß die Filterspulen (FL1, FL3 bzw. FL2, FL4) der einzelnen Filterstufen eines Tiefpaßfilters jeweils in Reihe und die Filterkondensatoren (FC1, FC3 bzw. FC2, FC4) der Filterstufen eines Tiefpaßfilters jeweils parallel zueinander geschaltet sind;
- daß die Filterkondensatoren (FC1, FC2 bzw. FC3, FC4) gleichrangiger Filterstufen (FL1, FC1; FL2, FC2 bzw. FL3, FC3; FL4, FC4) der beiden Tiefpaßfilter jeweils in Reihe geschaltet sind und
- daß die Verbindungspunkte (P8, P8′) zwischen zwei jeweils in Reihe geschalteten Filterkondensatoren (FC1, FC2 bzw. FC3, FC4) über die durchgehende Verbindungsleitung (VL) direkt mit dem Sternpunkt (P1) verbunden sind.

4. Leistungsverstärker nach einem der Ansprüche 2 bis 3, dadurch gekennzeichnet,
- daß die beiden in Reihe geschalteten Gleichspannungsnetzgeräte (UB1, UB2) in dem Verstärkermodul (V) durch zwei gegenpolig parallel an die dem Sternpunkt (P1) gegenüberliegenden Enden der Sekundärwicklungen (4) des Netztransformators (TR) angeschlossene und bezüglich des Sternpunktes (P1) zwei Gleichspannungen mit unterschiedlicher Polarität erzeugende Drehstrom-Stern-Gleichrichterschaltungen (G1, G3, G5 bzw. G2, G4, G6) mit jeweils einem nachgeschalteten und aus Siebdrossel (SL1 bzw. SL2) und Siebkondensator (SC1 bzw. SC2) bestehenden Siebglied (SL1, SC1 bzw. SL2, SC2) realisiert sind;
- daß die Siebkondensatoren (SC1, SC2) der beiden Siebglieder (SL1; SC1 bzw. SL2, SC2) in Reihe geschaltet sind und ihr gemeinsamer Verbindungspunkt der über die durchgehende Verbindungsleitung (VL) direkt an den Sternpunkt (P1) angeschlossene Verbindungspunkt (P2) der beiden in Reihe geschalteten Gleichspannungsnetzgeräte (UB1, UB2) ist.

5. Leistungsverstärker nach einem der Ansprüche 2 bis 4, dadurch gekennzeichnet,
- daß zwischen den beiden in Reihe geschalteten Gleichspannungsnetzgeräten (UB1, UB2) und den beiden in Reihe geschalteten Freilaufdioden (FD1, FD2) in dem Verstärkermodul (V) jeweils eine Reihenschaltung aus einem weiteren Schalter (SCH3; SCH4) und einem Widerstand (R1; R2) parallel zur der jeweiligen Freilaufdiode (FD1; FD2) geschaltet ist;
- daß diese beiden weiteren Schalter (SCH3; SCH4) jeweils komplementär, d.h. im Gegentakt zu dem zugehörigen ersten Schalter (SCH1; SCH2) geschaltet sind.

6. Leistungsverstärker nach einem der Ansprüche 2 bis 5, dadurch gekennzeichnet, daß jeder der beiden Endpunkte (P3; P4) der Gleichspannungsnetzgeräte-Reihenschaltung (UB1, UB2) jeweils über eine Kappdiode (KD1 ; KD2) mit dem ihm zugeordneten Ausgang (A; B) des Verstärkermoduls (V) verbunden ist.

7. Leistungsverstärker nach einem der Ansprüche 1 bis 6, dadurch gekennzeichnet, daß die von dem Eingangssignal abgeleitete Impulsfolge eine pulsfrequenzmodulierte Impulsfolge mit konstanter Impulsdauer ist.

8. Leistungsverstärker nach einem der Ansprüche 1 bis 6, dadurch gekennzeichnet, daß die aus dem Eingangssignal abgeleitete Impulsfolge eine pulsdauermodulierte Impulsfolge mit konstanter Schaltfrequenz ist.

9. Leistungsverstärker nach einem der Ansprüche 2 bis 8, dadurch gekennzeichnet, daß dem Netztransformator (TR) sekundärseitig Leistungs-Schutzrelais (RE1-RE3) nachgeschaltet sind.

10. Leistungsverstärker nach einem der Ansprüche 2 bis 9, dadurch gekennzeichnet, daß die Netztransformatoren der einzelnen Verstärkermoduln ($V_1$-$V_N$) zu einem Netztransformator (TR) mit einer Primärwicklung (2) und einer der Anzahl der Verstärkermoduln ($V_1$-$V_N$) entsprechenden Zahl von Sekundärwicklungen ($4_1$-$4'_N$) zusammengefaßt sind und daß bei Verwendung von Netztransformatoren mit Schirmung auch die Schirmungen zu einer gemeinsamen Schirmung (3) zusammengefaßt sind und daß für den Fall eines Drehstrom-Netztransformators mit der dreifachen Zahl von Primärwicklungen die Primärwicklungen (2) im Dreieck mit oder ohne Schwenkzipfel geschaltet sind.

11. Leistungsverstärker nach einem der Ansprüche 2 bis 9, dadurch gekennzeichnet, daß die Netztransformatoren der einzelnen Verstärkermoduln ($V_1$-$V_N$) durch zwei Netztransformatoren mit jeweils einer Primärwicklung und einer der halben Anzahl der Verstärkermoduln ($V_1$-$V_N$) entsprechenden Zahl von Sekundärwicklungen ersetzt sind und daß für den Fall von Drehstrom-Netztransformatoren mit der dreifachen Zahl von Primärwicklungen die Primärwicklungen des einen Netztransformators im Stern und die Primärwicklungen des anderen Netztransformators im Dreieck geschaltet sind.

12. Leistungsverstärker nach einem der Ansprüche 10 bis 11, dadurch gekennzeichnet, daß für den Fall von Drehstrom-Netztransformatoren in dem (den beiden) Netztransformator(en) für jeweils zwei Verstärkermoduln ($V_1$, $V_2$) ein Stützer (6) vorgesehen ist und daß über diesen Stützer (6) die Anschlüsse (A4, A8) für die beiden Sternpunkte ($P1_1$; $P1_2$) und die Anschlüsse (A1-A3; A5-A7) für die nicht im Sternpunkt zusammengeschalteten Enden der beiden Sekundärwicklungssätze ($4_1$; $4_2$) aus dem (den beiden) Netztransformator(en) herausgeführt sind.

13. Leistungsverstärker nach einem der Ansprüche 1 bis 12, dadurch gekennzeichnet, daß die Verstärkermoduln ($V_1$-$V_N$) gleich aufgebaut sind und im wesentlichen gleiche Ausgangssignale liefern.

14. Leistungsverstärker nach einem der Ansprüche 1 bis 13, dadurch gekennzeichnet, daß die Schalter (SCH1-SCH4) in den einzelnen Verstärkermoduln (V) jeweils aus einem Halbleiterschalter oder mehreren in Reihe und/oder parallel geschalteten Halbleiterschaltern bestehen.

15. Leistungsverstärker nach Anspruch 14, dadurch gekennzeichnet, daß die Halbleiterschalter MOS-Feldeffekttransistoren (MOSFET) oder Static-Induction-Transistoren (SIT) oder Static-Induction-Thyristoren (SITh) oder Abschaltthyristoren (GTO) oder Kaskade- oder Kaskode-Schaltungen sind.

16. Leistungsverstärker nach einem der Ansprüche 1 bis 15, dadurch gekennzeichnet, daß den ausgangsseitig in Reihe geschalteten Verstärkermoduln ($V_1$-$V_N$) ein zusätzliches Tiefpaßfilter (FL, FC) nachgeschaltet ist.

17. Leistungsverstärker nach einem der Ansprüche 1 bis 16, gekennzeichnet durch die Anwendung als Hochspannungs-Gleichstromversorgung insbesondere für Teilchenbeschleunigeranlagen.

18. Leistungsverstärker nach einem der Ansprüche 1 bis 16, gekennzeichnet durch die Anwendung als Modulationsverstärker insbesondere für anodenmodulierte Hochleistungs-Rundfunksender.

## Claims

1. Power amplifier for the amplification of an analog input signal, with at least two individual amplifiers, which are connected in series at the output and each consist of a switching amplifier connected at the secondary side and a low-pass filter connected therebehind, which switching amplifier contains a direct current mains unit (UB1, UB2) connected to a mains transformer (TR), a freewheel diode (FD1, FD2) connected in parallel thereto as well as a first switch (SCH1, SCH2), which is connected therebetween and controlled by a pulse sequence derived from the input signal, and which low-pass filter contains a filter coil (FL1, FL2) connected in series with the first switch as well as a filter capacitor (FC1, FC2), which is connected behind the filter coil and in parallel with the freewheel diode, and is so dimensioned in its upper limit frequency that the analog input signal is present at its output in amplified and substantially undistorted form, characterised thereby, that each two individual amplifiers, which are connected in series one directly behind the other, are so combined into an amplifier module
    - that the direct current mains units (UB1, UB2), the freewheel diodes (FD1, FD2) as well as the filter capacitors (FC1, FC2) of both the individual amplifiers are each time connected one in series with the other in the one amplifier module (V) or in the several amplifier modules ($V_1$ to $V_N$) connected in series at the output,
    - that the mains transformers of both the individual amplifiers are combined into one mains transformer (TR), which is common to both direct current mains units (UB1, UB2) and preferably constructed as a three-phase one, with secondary windings (4) connected together in a star point,
    - that the junctions (P2, P5, P8) between the direct current mains units (UB1, UB2) connected in series, the freewheel diodes (FD1, FD2) connected in series and the filter capacitors (FC1, FC2) connected in series are connected by way of a continuous connecting line (VL) with the star point (P1) either directly or by way of a coupling capacitor or by way of a rejector circuit, and
    - that the end points (P3, P6, P9; P4, P7, P10) of the three series connections of the direct current mains units (UB1, UB2), the freewheel diodes (FD1, FD2) and the filter capacitors (FC1, FC2) are each time connected together by way of a further series connection of a switch (SCH1, SCH2) and a filter coil (FL1, FL2) and the series connection of the freewheel diodes (FD1, FD2) is in that case each time connected with its end points between the switch (SCH1, SCH2) and the filter coil (FL1, FL2).

16

2. Power amplifier according to claim 1, characterised thereby, that the transformer capacitances which are integrated as parts of the individual low-pass filters, in particular the screen capacitances (CT) and/or the shunt capacitances (CQ), are included in the dimensioning of the individual low-pass filters in respect of their upper limit frequency (Figure 16).

3. Power amplifier according to claim 2, characterised thereby,
- that both the low-pass filters in the amplifier module (V) each consist of several filter stages (FL1, FC1; FL3, FC3 or FL2, FC2; FL4, FC4) connected one behind the other,
- that the individual filter stages each contain a filter coil (FL1 to FL4) and a filter capacitor (FC1 to FC4) connected behind the respective filter coil,
- that the filter coils (FL1, FL3 or FL2, FL4) of the individual filter stages of a low-pass filter are each time connected in series and the filter capacitors (FC1, FC3 or FC2, FC4) of the filter stages of a low-pass filter are each time connected in parallel,
- that the filter capacitors (FC1, FC2 or FC3, FC4) of filter stages (FL1, FC1; FL2, FC2 or FL3, FC3; FL4, FC4) of equal rank of both the low-pass filters are each time connected in series, and
- that the junctions (P8, P8') between two filter capacitors (FC1, FC2 or FC3, FC4) respectively connected in series are connected directly with the star point (P1) by way of the continuous connecting line (VL).

4. Power amplifier according to one of the claims 2 and 3, characterised thereby,
- that both the direct current mains units (UB1, UB2) connected in series in the amplifier module (V) are realised by two polyphase star-connected rectifier circuits (G1, G3, G5 or G2, G4, G5), which are connected with opposite polarity in parallel to those ends of the secondary windings (4) of the mains transformer (TR), which lie opposite the star point (P1), and produce two direct voltages of opposite polarity with respect to the star point (P1) and which each comprise a smoothing member (SL1, SC1 or SL2, SC2) connected therebehind and consisting of a smoothing choke (SL1 or SL2) and a smoothing capacitor (SC1 or SC2) and
- that the smoothing capacitors (SC1, SC2) of both the smoothing members (SL1, SC1 or SL2, SC2) are connected in series and their common junction is the junction (P2), which is connected directly with the star point (P1) by way of the continuous connecting line (VL), of the two direct current mains units (UB1, UB2) connected in series.

5. Power amplifier according to one of the claims 2 to 4, characterised thereby,
- that a respective series connection of a further switch (SCH3; SCH4) and a resistor (R1; R2) is connected in parallel to the respective freewheel diode (FD1; FD2) in the amplifier module (V) between both the direct current mains units (UB1, UB2) connected in series and both the freewheel diodes (FD1, FD2) connected in series and
- that both these further switches (SCH3; SCH4) are each connected complementarily, i.e. in opposite phase, to the respectively associated first switch (SCH1; SCH2).

6. Power amplifier according to one of the claims 2 to 5, characterised thereby, that each of both the end points (P3; P4) of the series connection of the direct current mains units (UB1, UB2) is connected by way of a respective Kapp diode (KD1; KD2) with the respectively associated output (A; B) of the amplifier module (V).

7. Power amplifier according to one of the claims 1 to 6, characterised thereby, that the pulse sequence derived from the input signal is a pulse-frequency-modulated pulse sequence of constant pulse duration.

8. Power amplifier according to one of the claims 1 to 6, characterised thereby, that the pulse sequence derived from the input signal is a pulse-duration-modulated pulse sequence of constant switching frequency.

9. Power amplifier according to one of the claims 2 to 8, characterised thereby, that circuit breaker relays (RE1 to RE3) are connected behind the mains transformer (TR) at the secondary side.

10. Power amplifier according to one of the claims 2 to 9, characterised thereby, that the mains transformers of the individual amplifier modules ($V_1$ to $V_N$) are combined into one mains transformer (TR) with one primary winding (2) and a number of secondary windings ($4_1$ to $4'_N$), which corresponds to the number of the amplifier modules ($V_1$ to $V_N$), and that in the case of the use of mains transformers with screening also the screens are combined into a common screen (3) and that, for the case of a polyphase alternating current mains transformer with three times the number of primary windings, the primary windings (2) are connected in delta with or without swivel lobe.

11. Power amplifier according to one of the claims 2 to 9, characterised thereby, that the mains transformers of the individual amplifier modules ($V_1$ to $V_N$) are replaced by two mains transformers each with a respective primary winding and a number of secondary windings, which corresponds to half the number of the amplifier modules ($V_1$ to $V_N$) and that for the case of polyphase alternating current mains transformers with three times the number of primary windings, the primary windings of the one mains transformer are connected in star and the primary windings of the other mains transformer are connected in delta.

12. Power amplifier according to one of the claims 10 and 11, characterised thereby, that for the case of polyphase alternating current mains transformers, a pin socket (6) is provided for each two amplifier modules ($V_1$, $V_2$) in the one mains transformer or in both mains transformers and that the connections (A4, A8) for both the star points ($P1_1$; $P1_2$) and the connections (A1 to A3; A5 to A7) for those ends of both the sets of secondary windings ($4_1$; $4_2$), which are not connected together in the star point, are led out of the one mains transformer or both means transformers by way of this pin socket (6).

13. Power amplifier according to one of the claims 1 to 12, characterised thereby, that the amplifier modules ($V_1$ to $V_N$) are constructed identically and supply substantially equal output signals.

14. Power amplifier according to one of the claims 1 to 13, characterised thereby, that the switches (SCH1 to SCH4) in the individual amplifier modules ($V_1$) each consist of a respective semiconductor switch or of several semiconductor switches connected in series and/or parallel.

15. Power amplifier according to claim 14, characterised thereby, that the semiconductor switches are MOS field effect transistors (MOSFET) or static induction transistors (SIT) or static induction thyristors (SITh) or cut-off thyristors (GTO) or cascade or cascode circuits.

16. Power amplifier according to one of the claims 1 to 15, characterised thereby, that an additional low-pass filter (FL, FC) is connected behind the amplifier modules ($V_1$ to $V_N$) connected in series at the output.

17. Power amplifier according to one of the claims 1 to 16, characterised by the use as high-voltage direct current supply in particular for particle accelerator installations.

18. Power amplifier according to one of the claims 1 to 16, characterised by the use as modulation amplifier in particular for anode-modulated high-power radio transmitters.

**Revendications**

1. Amplificateur de puissance en vue de l'amplification d'un signal d'entrée analogique, comportant au moins deux amplificateurs individuels montés en série côté sortie, qui se composent chacun d'un amplificateur de commutation disposé côté secondaire et d'un filtre passe-bas disposé en aval, amplificateur de commutation qui comprend un bloc d'alimentation secteur à tension continue (UB1, UB2) relié à un transformateur d'alimentation secteur (TR), une diode non asservie (FD1, FD2) montée en parallèle sur celui-ci ainsi qu'un premier commutateur (SCH1, SCH2) disposé entre les deux et commandé par un train d'impulsions dérivé du signal d'entrée, et le filtre passe-bas comportant une bobine de filtre (FL1, FL2) disposée en série avec le premier commutateur ainsi qu'un condensateur de filtre (FC1, FC2) monté en aval de la bobine de filtre et en parallèle sur la diode non asservie et est dimensionné dans sa fréquence limite supérieure de sorte qu'à sa sortie le signal d'entrée analogique est amplifié et apparaît sensiblement sans distorsion, caractérisé
en ce que deux amplificateurs individuels montés en série directement en succession sont réunis en un module d'amplificateur,
  - en ce que dans un module d'amplificateur (V) ou dans plusieurs modules d'amplificateur ($V_1$-$V_N$) montés en série côté sortie, les blocs d'alimentation secteur à tension continue (UB1, UB2), les diodes non asservies (FD1, FD2) ainsi que les condensateurs de filtre (FC1, FC2) des deux amplificateurs individuels sont montés en série entre eux ;
  - en ce que les transformateurs d'alimentation secteur des deux amplificateurs individuels sont réunis en un transformateur d'alimentation secteur (TR) réalisé de préférence de façon triphasée, commun pour les deux blocs d'alimentation secteur à courant continu (UB1, UB2) avec des enroulements secondaires (4) réunis en un point neutre (P1) ;

- en ce que les points de liaison (P2, P5, P8) entre les blocs d'alimentation secteur à tension continue (UB1,UB2) montés en série, les diodes non asservies (FD1, FD2) montées en série et les condensateurs de filtre (FC1, FC2) montés en série sont réunis par l'intermédiaire d'une ligne de liaison continue (VL) directement ou par l'intermédiaire d'un condensateur de couplage ou par l'intermédiaire d'un circuit bouchon au point neutre (P1) ;
- en ce que les points terminaux (P3, P6, P9 ; P4, P7, P10) des trois montages série se composant des blocs d'alimentation secteur à tension continue (UB1, UB2), de diodes non asservies (FD1, FD2) et de condensateurs de filtre (FC1, FC2) sont réunis entre eux respectivement par un autre montage série se composant de commutateurs (SCH1, SCH2) et de bobines de filtre (FL1, FL2), et le montage en série des diodes non asservies (FD1, FD2) est relié par leurs points terminaux (P6, P7) chacun entre les commutateurs (SCH1, SCH2) et les bobines de filtre (FL1, FL2).

2. Amplificateur de puissance selon la revendication 1, caractérisé en ce que lors du dimensionnement des différents filtres passe-bas en ce qui concerne leur fréquence limite supérieure, les capacités de transformateur intégrées en tant que parties des différents filtres passe-bas, en particulier les capacités de blindage (CT) et/ou les capacités parallèles (CQ), sont incluses (Figure 16).

3. Amplificateur de puissance selon la revendication 2, caractérisé
- en ce que les deux filtres passe-bas dans le module d'amplificateur (V) se composent chacun de plusieurs étages de filtre disposés en succession (FL1, FC1 ; FL3, FC3 ou FL2, FC2 ; FL4, FC4) ;
- en ce que les différents étages de filtre contiennent chacun une bobine de filtre (FL1-FL4) et un condensateur de filtre (FC1-FC4) disposé en aval de la bobine de filtre respective ;
- en ce que les bobines de filtre (FL1, FL3 ou FL2, FL4) des différents étages de filtre d'un filtre passe-bas sont disposées respectivement en série et des condensateurs de filtre (FC1, FC3 ou FC2, FC4) des étages de filtre d'un filtre passe-bas respectivement en parallèle entre eux ;
- en ce que les condensateurs de filtre (FC1, FC2 ou FC3, FC4) d'étages de filtre de même bande (FL1, FC1 ; FL2, FC2 ou FL3, FC3 ; FL4, FC4) des deux filtres passe-bas sont disposés en série et
- en ce que les points de liaison (P8, P8') entre deux condensateurs de filtre (FC1, FC2 ou FC3, FC4) montés en série sont réunis directement au point neutre (P1) par l'intermédiaire de la ligne de liaison continue (VL).

4. Amplificateur de puissance selon l'une des revendications 2 ou 3, caractérisé,
- en ce que les deux blocs d'alimentation secteur à tension continue (UB1, UB2) montés en série dans le module d'amplificateur (V) sont réalisés par deux circuits redresseurs en étoile triphasés (G1, G3, G5 ou G2, G4, G6) reliés en opposition en parallèle aux extrémités en vis-à-vis du point neutre (P1) des enroulements secondaires (4) du transformateur d'alimentation secteur (TR) et produisant par rapport au point neutre (P1) deux tensions de polarité différente avec chacun un élément de filtrage (SL1, SC1 ou SL2, SC2) disposé en aval et se composant d'une bobine de filtrage (SL1 ou SL2) et d'un condensateur de filtrage (SC1 ou SC2) ;
- en ce que les condensateurs de filtrage (SC1, SC2) des deux éléments de filtrage (SL1 , SC1 ou SL2, SC2) sont montés en série et leur point de liaison commun au point de liaison (P2) relié par l'intermédiaire de la ligne de liaison continue (VL) directement au point neutre (P1) des deux blocs d'alimentation secteur à tension continue montés en série (UB1, UB2).

5. Amplificateur de puissance selon l'une des revendications 2 à 4, caractérisé,
- en ce qu'entre les deux blocs d'alimentation secteur à tension continue montés en série (UB1, UB2) et les deux diodes non asservies montées en série (FD1, FD2) dans le module d'amplificateur (V) est disposé en parallèle sur la diode non asservie respective (FD1, FD2) un montage série se composant d'un autre commutateur (SCH3, SCH4) et d'une résistance (R1 ; R2) ;
- et en ce que ces deux autres commutateurs (SCH3 ; SCH4) sont montés de façon complémentaire, c'est-à-dire en opposition au premier commutateur associé (SCH1 ; SCH2).

6. Amplificateur de puissance selon l'une des revendications 2 à 5, caractérisé en ce que chacun des deux points terminaux (P3, P4) du montage en série des blocs d'alimentation secteur à tension continue (UB1, UB2) est relié par l'intermédiaire d'une diode de coupure (KD1, KD2 ) à la sortie (A ; B) qui lui est associée du module d'amplificateur (V).

7. Amplificateur de puissance selon l'une des revendications 1 à 6, caractérisé en ce que le train d'impulsions dérivé du signal d'entrée est un train d'impulsions modulées en fréquence à durée d'impulsion constante.

8. Amplificateur de puissance selon l'une des revendications 1 à 6, caractérisé en ce que le train d'impulsions dérivé du signal d'entrée est un train d'impulsions modulées en durée à fréquence de commutation constante.

9. Amplificateur de puissance selon l'une des revendications 2 à 8, caractérisé en ce qu'en aval du transformateur d'alimentation secteur (TR) sont disposés côté secondaire des relais de protection de puissance (RE1-RE3).

10. Amplificateur de puissance selon l'une des revendications 2 à 9, caractérisé en ce que les transformateurs d'alimentation secteur des différents module d'amplificateur ($V_1$-$V_N$) sont réunis en un transformateur d'alimentation secteur (TR) avec un enroulement primaire (2) et un nombre d'enroulements secondaires ($4_1$-$4'_N$) correspondant au nombre des modules d'amplificateur ($V_1$-$V_N$) et en ce que dans le cas de l'utilisation de transformateurs d'alimentation secteur avec blindage, également les blindages sont réunis un blindage commun (3) et en ce que pour le cas d'un transformateur d'alimentation secteur triphasé avec un nombre triple d'enroulements primaires, les enroulements primaires (2) sont montés en triangle avec ou sans pointe pivotante.

11. Amplificateur de puissance selon l'une des revendications 2 à 9, caractérisé en ce que les transformateurs d'alimentation secteur des différents modules d'amplificateur ($V_1$-$V_N$) sont remplacés par des transformateurs d'alimentation secteur avec chacun un enroulement primaire et un nombre d'enroulements secondaires correspondant à la moitié du nombre des modules d'amplificateur ($V_1$-$V_N$) et en ce que dans le cas de transformateurs d'alimentation secteur triphasés avec un nombre triple d'enroulements primaires, les enroulements primaires d'un transformateur d'alimentation secteur sont montés en étoile et les enroulements primaires de l'autre transformateur d'alimentation secteur sont montés en triangle.

12. Amplificateur de puissance selon l'une des revendications 10 ou 11, caractérisé en ce que dans le cas de transformateur d'alimentation secteur triphasés dans le (les deux) transformateur(s) d'alimentation secteur pour deux modules d'amplificateur ($V_1$, $V_2$), un isolateur (6) est prévu et en ce qu'au moyen de cet isolateur (6) les raccordements (A4, A8) pour les deux points neutres ($P1_1$ ; $P1_2$) et les raccordements (A1-A3 ; A5-A7) pour les extrémités non réunies au point neutre des deux ensembles d'enroulements secondaires ($4_1$ ; $4_2$) sont extraits du (des deux) transformateur(s) d'alimentation secteur.

13. Amplificateur de puissance selon l'une des revendications 1 à 12, caractérisé en ce que les modules d'amplificateur ($V_1$-$V_N$) sont de réalisation identique et délivrent sensiblement des signaux identiques.

14. Amplificateur de puissance selon l'une des revendications 1 à 13, caractérisé en ce que les commutateurs (SCH1-SCH4) dans les différents modules d'amplificateur (V) se composent chacun d'un commutateur à semiconducteurs ou de plusieurs commutateurs à semiconducteurs disposés en série et/ou en parallèle.

15. Amplificateur de puissance selon la revendication 14, caractérisé en ce que les commutateurs semiconducteurs sont des transistors à effet de champ MOS (MOSFET) ou des transistors à induction statique (SIT) ou des thyristors à induction statique (SITh) ou des transistors à coupure par la grille (GTO) ou des circuits cascade ou cascode.

16. Amplificateur de puissance selon l'une des revendications 1 à 15, caractérisé en ce qu'en aval des modules d'amplificateur ($V_1$-$V_N$) montés en série côté sortie est disposé un filtre passe-bas supplémentaire (FL, FC).

17. Amplificateur de puissance selon l'une des revendications 1 à 16, caractérisé par l'application en tant qu'alimentation à courant continu à tension élevée en particulier pour des installations d'accélérateurs de particules.

18. Amplificateur de puissance selon l'une des revendications 1 à 16, caractérisé par l'application en tant qu'amlificateur de modulation, en particulier pour des émetteurs de radiodiffusion de grande puissance modulés par l'anode.

FIG. 1

FIG. 2

FIG. 3

EP 0 349 743 B1

FIG. 4

FIG. 5

22

FIG. 6

FIG. 7

FIG. 8

FIG. 9

FIG. 10

FIG. 11

24

FIG. 12

FIG. 13

FIG. 14

FIG. 15

FIG.16

FIG. 17

FIG.18

FIG. 19

FIG. 20

FIG. 21

FIG. 22